(19) Europäisches Patentamt
European Patent Office
Office européen des brevets

(11) **EP 3 022 568 B1**

(12) **EUROPÄISCHE PATENTSCHRIFT**

(45) Veröffentlichungstag und Bekanntmachung des Hinweises auf die Patenterteilung:
**29.03.2017 Patentblatt 2017/13**

(21) Anmeldenummer: **14741535.0**

(22) Anmeldetag: **03.07.2014**

(51) Int Cl.:
*B60L 11/02* (2006.01)    *B60L 11/18* (2006.01)
*H02M 3/158* (2006.01)    *G01R 31/36* (2006.01)
*G01R 31/00* (2006.01)

(86) Internationale Anmeldenummer:
**PCT/EP2014/064157**

(87) Internationale Veröffentlichungsnummer:
**WO 2015/007530 (22.01.2015 Gazette 2015/03)**

(54) **BORDNETZ UND VERFAHREN ZUM BETREIBEN EINES BORDNETZES**

ONBOARD POWER SUPPLY AND METHOD FOR OPERATING AN ONBOARD POWER SUPPLY

RÉSEAU DE BORD ET PROCÉDÉ PERMETTANT DE FAIRE FONCTIONNER UN RÉSEAU DE BORD

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.07.2013 DE 102013213946**

(43) Veröffentlichungstag der Anmeldung:
**25.05.2016 Patentblatt 2016/21**

(73) Patentinhaber: **Continental Automotive GmbH 30165 Hannover (DE)**

(72) Erfinder:
• **REICHOW, Dirk**
  **93173 Wenzenbach (DE)**
• **VÖLKL, Peter**
  **93173 Wenzenbach (DE)**
• **SCHEURER, Michael**
  **85256 Vierkirchen (DE)**

(56) Entgegenhaltungen:
WO-A1-2012/160754    DE-A1-102007 006 477
DE-A1-102011 086 829    DE-A1-102011 087 678
US-A1- 2013 038 289

**Beschreibung**

Die Anmeldung betrifft ein Bordnetz für ein Fahrzeug und ein Verfahren zum Betreiben eines Bordnetzes.

Aus der DE 10 2007 006 477 A1 ist ein Verfahren zur Ermittlung des Innenwiderstandes einer Fahrzeugbatterie bekannt.

Das Verfahren dient zur Überwachung des Gesundheitszustandes eines elektrischen Energiespeichers eines Fahrzeugs, insbesondere einer Fahrzeugbatterie oder eines Superkondensators, über eine Bestimmung des Innenwiderstandes $R_i$ des Energiespeichers. Bei dem Verfahren wird der Innenwiderstand über eine Spannungsveränderung der Spannung des Energiespeichers durch Zu- oder Abschalten eines an das Bordnetz des Fahrzeugs angeschlossenen Verbrauchers $R_{Li}$ ermittelt wird, wobei die Spannung des Energiespeichers $U_o$ bei ausgeschaltetem Verbraucher $R_{Li}$ und die Spannung $U_{Bat}$ des Energiespeichers bei eingeschaltetem Verbraucher gemessen und daraus ein Spannungsunterschied $\Delta U_{Bat}$ ermittelt wird, wobei der Innenwiderstand $R_i$ durch die Formel $R_i = \Delta U_{Bat} / U_o \times R_{Li}$ ermittelt wird.

Die Druckschrift DE 10 2011 086 829 A1 betrifft ein Bordnetz mit zwei Bordnetzzweigen unterschiedlicher Nominalspannung.

Es wird eine Momentanspannung mit oberen und unteren Schwellenwerten verglichen, um so einen DC/DC-Wandler anzusteuern.

Die Druckschrift DE 10 2011 087 678 A1 betrifft eine Vorrichtung zur Zustandserfassung für einen Akkumulator, wobei ein Testsignalmodul ein Testsignal über einen Wandler an den Akkumulator anlegt.

Die Druckschrift US 2013/038289 A1 betrifft einen Batteriewandler für eine Batterie, wobei die Ausgangsspannungen einzelner Batteriezellen erfasst werden.

Die Druckschrift WO 2012/160754 A1 betrifft eine Batteriespeichereinheit mit einer Ausgleichsschaltung, wobei einzelne Zellspannungen mit Schwellenwerten verglichen werden.

Aufgabe von Ausführungsformen der Erfindung ist es ein Bordnetz für ein Fahrzeug und ein Verfahren zum Betreiben eines Bordnetzes anzugeben, welche eine weiter verbesserte Ermittlung eines Innenwiderstands eines Energiespeichers ermöglichen.

Diese Aufgabe wird mit dem Gegenstand der unabhängigen Ansprüche gelöst. Vorteilhafte Weiterbildungen ergeben sich aus den abhängigen Ansprüchen.

Ein erster Aspekt der Erfindung betrifft ein Bordnetz für ein Fahrzeug, wobei das Bordnetz einen ersten Bordnetzzweig aufweist, wobei der erste Bordnetzzweig einen ersten Energiespeicher aufweist. Zudem weist das Bordnetz einen zweiten Bordnetzzweig auf, wobei der zweite Bordnetzzweig einen zweiten Energiespeicher aufweist. Ferner weist das Bordnetz einen DC/DC-Wandler auf, der zum bidirektionalen Übertragen von Energie zwischen dem ersten Bordnetzzweig und dem zweiten Bordnetzzweig ausgebildet ist. Darüber hinaus weist das Bordnetz eine erste Schaltvorrichtung und eine zweite Schaltvorrichtung auf, wobei ein erster Anschluss des zweiten Energiespeichers mittels der ersten Schaltvorrichtung und der zweiten Schaltvorrichtung über einen ersten Knotenpunkt, einen zweiten Knotenpunkt und einen dritten Knotenpunkt mit einem ersten Anschluss des ersten Energiespeichers elektrisch koppelbar ist. Weiterhin weist das Bordnetz eine erste Stromermittlungseinheit, ausgebildet zum Ermitteln eines ersten Stromwerts eines zwischen dem ersten Anschluss des ersten Energiespeichers und dem ersten Knotenpunkt fließenden ersten Stroms, eine zweite Stromermittlungseinheit ausgebildet zum Ermitteln eines zweiten Stromwerts eines über die erste Schaltvorrichtung und die zweite Schaltvorrichtung fließenden zweiten Stroms, eine dritte Stromermittlungseinheit ausgebildet zum Ermitteln eines dritten Stromwerts eines zwischen dem ersten Anschluss des zweiten Energiespeichers und dem zweiten Knotenpunkt fließenden dritten Stroms und eine vierte Stromermittlungseinheit ausgebildet zum Ermitteln eines vierten Stromwerts eines zwischen dem dritten Knotenpunkt und dem DC/DC-Wandler fließenden vierten Stroms auf. Ferner weist das Bordnetz einen elektrischen Widerstand auf, wobei der elektrische Widerstand mittels einer dritten Schaltvorrichtung mit dem ersten Anschluss des zweiten Energiespeichers elektrisch koppelbar ist. Darüber hinaus weist das Bordnetz eine Spannungsermittlungseinheit auf, wobei die Spannungsermittlungseinheit ausgebildet ist zum Ermitteln eines ersten Spannungswerts einer Spannung des zweiten Energiespeichers, wenn der elektrische Widerstand von dem ersten Anschluss des zweiten Energiespeichers elektrisch getrennt ist und zum Ermitteln eines zweiten Spannungswerts der Spannung des zweiten Energiespeichers, wenn der elektrische Widerstand mit dem ersten Anschluss des zweiten Energiespeichers elektrisch gekoppelt ist. Zudem weist das Bordnetz eine Innenwiderstands-Ermittlungseinheit auf, wobei die Innenwiderstands-Ermittlungseinheit ausgebildet ist zum Ermitteln eines, einen Innenwiderstand des zweiten Energiespeichers kennzeichnenden Widerstandswerts basierend auf dem ermittelten ersten Spannungswert und dem ermittelten zweiten Spannungswert und zum Klassifizieren des ermittelten Widerstandswerts basierend auf den ermittelten ersten, zweiten, dritten und vierten Stromwerten.

Ein weiterer Aspekt der Erfindung betrifft ein Bordnetz für ein Fahrzeug, wobei das Bordnetz einen ersten Bordnetzzweig aufweist, wobei der erste Bordnetzzweig einen ersten Energiespeicher aufweist. Zudem weist das Bordnetz einen zweiten Bordnetzzweig auf, wobei der zweite Bordnetzzweig einen zweiten Energiespeicher aufweist, wobei ein erster Anschluss des zweiten Energiespeichers über einen ersten Knotenpunkt und einen zweiten Knotenpunkt mit einem ersten Anschluss des ersten Energiespeichers elektrisch koppelbar ist. Ferner weist das Bordnetz einen DC/DC-Wandler auf, der zum bidirektionalen Übertragen von Energie zwischen dem ersten Bordnetzzweig und dem zweiten Bordnetzzweig ausgebildet ist. Darüber hinaus weist das Bordnetz eine erste Schaltvorrichtung und eine zweite Schaltvorrichtung auf, wobei der erste Anschluss des zweiten Energiespeichers mittels der ersten Schaltvorrichtung und der zweiten Schaltvorrichtung mit einem Bezugspotential elektrisch koppelbar ist. Weiterhin weist das Bordnetz eine erste Stromermittlungseinheit ausgebildet zum Ermitteln eines ersten Stromwerts eines zwischen dem ersten Anschluss des ersten Energiespeichers und dem ersten Knotenpunkt fließenden ersten Stroms, eine zweite Stromermittlungseinheit ausgebildet zum Ermitteln eines zweiten Stromwerts eines über die erste Schaltvorrichtung fließenden zweiten Stroms, eine dritte Stromermittlungseinheit ausgebildet zum Ermitteln eines dritten Stromwerts eines zwischen dem ersten Anschluss des zweiten Energiespeichers und dem zweiten Knotenpunkt fließenden dritten Stroms und eine vierte Stromermittlungseinheit ausgebildet zum Ermitteln eines vierten Stromwerts eines zwischen dem ersten Knotenpunkt und dem DC/DC-Wandler und/oder eines zwischen dem zweiten Knotenpunkt und dem DC/DC-Wandler fließenden vierten Stroms auf. Ferner weist das Bordnetz einen elektrischen Widerstand auf, wobei der elektrische Widerstand mittels einer dritten Schaltvorrichtung mit dem ersten Anschluss des zweiten Energiespeichers elektrisch koppelbar ist. Darüber hinaus weist das Bordnetz eine Spannungsermittlungseinheit auf, wobei die Spannungsermittlungseinheit ausgebildet ist zum Ermitteln eines ersten Spannungswerts einer Spannung des zweiten Energiespeichers, wenn der elektrische Widerstand von dem ersten Anschluss des zweiten Energiespeichers elektrisch getrennt ist und zum Ermitteln eines zweiten Spannungswerts der Spannung des zweiten Energiespeichers, wenn der elektrische Widerstand mit dem ersten Anschluss des zweiten Energiespeichers elektrisch gekoppelt ist. Zudem weist das Bordnetz eine Innenwiderstands-Ermittlungseinheit auf, wobei die Innenwiderstands-Ermittlungseinheit ausgebildet ist zum Ermitteln eines, einen Innenwiderstand des zweiten Energiespeichers kennzeichnenden Widerstandswerts basierend auf dem ermittelten ersten Spannungswert und dem ermittelten zweiten Spannungswert und zum Klassifizieren des ermittelten Widerstandswerts basierend auf den ermittelten ersten, zweiten, dritten und vierten Stromwerten.

Das Bordnetz gemäß den genannten Aspekten bzw. Varianten der Erfindung ermöglicht eine weiter verbesserte Ermittlung eines den Innenwiderstand des zweiten Energiespeichers kennzeichnenden Widerstandswerts. Dies erfolgt insbesondere durch das Vorsehen der ersten, zweiten, dritten und vierten Stromermittlungseinheit, der Spannungsermittlungseinheit sowie der zum Ermitteln eines, einen Innenwiderstand des zweiten Energiespeichers kennzeichnenden Widerstandswerts basierend auf dem ermittelten ersten Spannungswert und dem ermittelten zweiten Spannungswert und zum Klassifizieren des ermittelten Widerstandswerts basierend auf den ermittelten ersten, zweiten, dritten und vierten Stromwerten ausgebildeten Innenwiderstands-Ermittlungseinheit. Dadurch kann, wie im Folgenden näher erläutert wird, bestimmt werden, ob die Ermittlung des den Innenwiderstand des zweiten Energiespeichers kennzeichnenden Widerstandswerts zu einem geeigneten Zeitpunkt bzw. während eines geeigneten Systemzustands des Bordnetzes erfolgt und somit eine Verifikation bzw. Plausibilisierung des ermittelten Widerstandswerts erfolgen.

Eine möglichst genaue Kenntnis des den Innenwiderstand des zweiten Energiespeichers kennzeichnenden Widerstandswerts ist dabei von besonderer Bedeutung im Hinblick auf Sicherheits- und Verfügbarkeitsaspekte des Bordnetzes. Insbesondere kann basierend auf dem ermittelten Widerstandswert ein Gesundheitszustand des zweiten Energiespeichers, welcher auch als SOH (SOH, State of Health) bezeichnet wird, ermittelt bzw. prognostiziert werden. Dies ist besonders vorteilhaft bei Fahrzeugen, welche ein Stopp/Start-System bzw. ein Start/Stopp-System aufweisen, die insbesondere zum automatischen Abschalten bzw. Starten eines Verbrennungsmotors des Fahrzeugs ausgebildet sind. Beispielsweise kann ermittelt werden, ob der Gesundheitszustand des zweiten Energiespeichers ausreichend ist, um nach einem automatischen Abschalten des Verbrennungsmotors einen Neustart des Verbrennungsmotors durchzuführen.

In einer Ausführungsform der genannten Bordnetze weist der elektrische Widerstand einen vorbestimmten Widerstandswert auf. Dadurch ist es nicht erforderlich, den Wert des elektrischen Widerstands zu messen, sondern der vorbestimmte Widerstandswert kann für das Ermitteln des den Innenwiderstand des zweiten Energiespeichers kennzeichnenden Widerstandswerts verwendet werden.

In einer weiteren Ausführungsform ist die Innenwiderstands-Ermittlungseinheit zudem ausgebildet zum Klassifizieren des ermittelten Widerstandswerts basierend auf dem ermittelten ersten Spannungswert und dem ermittelten zweiten Spannungswert. Dies ermöglicht in vorteilhafter Weise eine weiter verbesserte Plausibilisierung des ermittelten, den Innenwiderstand des zweiten Energiespeichers kennzeichnenden Widerstandswerts, wie im Folgenden näher erläutert wird.

Der erste Bordnetzzweig kann zudem einen ersten elektrischen Verbraucher aufweisen.

Der DC/DC-Wandler, die erste Schaltvorrichtung, die zweite Schaltvorrichtung, die dritte Schaltvorrichtung, der elektrische Widerstand und die Innenwiderstands-Ermittlungseinheit sind in einer weiteren Ausführungsform Bestandteil einer Steuereinheit, die auch als Control Unit bezeichnet wird. Damit können die genannten Komponenten in einem einzigen Modul in Form der Steuereinheit bereitgestellt werden.

Die erste Schaltvorrichtung, die zweite Schaltvorrichtung und die dritte Schaltvorrichtung können ausgewählt sein aus der Gruppe, bestehend aus einem Relais und einem Halbleiterschalter, insbesondere einem MOSFET-Schalter oder einem IGBT-Schalter. Damit kann eine elektrische Kopplung bzw. Trennung der jeweiligen Komponenten des Bordnetzes über die genannten Schaltvorrichtungen in einfacher und zuverlässiger Weise erfolgen.

Der zweite Bordnetzzweig kann zudem einen zweiten elektrischen Verbraucher aufweisen. Weiterhin kann das Bordnetz einen dritten Bordnetzzweig aufweisen, wobei der dritte Bordnetzzweig einen dritten elektrischen Verbraucher aufweist.

In einer weiteren Ausgestaltung weist das Bordnetz zudem einen Starter eines Verbrennungsmotors des Fahrzeugs und/oder einen Generator auf. Der Starter kann dabei insbesondere als Ritzelstarter oder als Riemenstarter ausgebildet sein und der Generator Bestandteil des ersten Bordnetzzweigs oder des dritten Bordnetzzweigs sein.

Der DC/DC-Wandler ist in einer Ausgestaltung als Synchronwandler ausgebildet. Damit kann ein Energieübertrag zwischen dem ersten Bordnetzzweig, dem zweiten Bordnetzzweig sowie gegebenenfalls dem dritten Bordnetzzweig in einfacher Weise ermöglicht werden.

Der erste Energiespeicher und der zweite Energiespeicher sind beispielsweise ausgewählt aus der Gruppe, bestehend aus zumindest einem Akkumulator, insbesondere zumindest einem Li-Ionen-Akkumulator oder zumindest einem BleisäureAkkumulator, und zumindest einem Kondensator, insbesondere zumindest einem Doppelschichtkondensator, sowie Kombinationen der genannten Elemente.

Die Erfindung betrifft zudem ein Fahrzeug, das ein Bordnetz gemäß einer der genannten Ausführungsformen aufweist. Das Fahrzeug ist beispielsweise ein Kraftfahrzeug, insbesondere ein Personenkraftwagen oder ein Lastkraftwagen, und kann als Hybridfahrzeug oder als Fahrzeug mit alleinigem Verbrennungsmotor-Antrieb ausgebildet sein.

Ein weiterer Aspekt der Erfindung betrifft ein Verfahren zum Betreiben eines Bordnetzes gemäß einer der genannten Ausführungsformen, wobei das Verfahren folgende Schritte aufweist. Es erfolgt ein Ermitteln eines ersten Spannungswerts einer Spannung des zweiten Energiespeichers mittels der Spannungsermittlungseinheit, eines ersten Stromwerts mittels der ersten Stromermittlungseinheit, eines zweiten Stromwerts mittels der zweiten Stromermittlungseinheit, eines dritten Stromwerts mittels der dritten Stromermittlungseinheit und eines vierten Stromwerts mittels der vierten Stromermittlungseinheit, wenn der elektrische Widerstand von dem ersten Anschluss des zweiten Energiespeichers elektrisch getrennt ist. Zudem erfolgt ein Schließen der dritten Schaltvorrichtung. Ferner erfolgt ein Ermitteln eines zweiten Spannungswerts der Spannung des zweiten Energiespeichers und ein wiederholtes Ermitteln eines ersten Stromwerts mittels der ersten Stromermittlungseinheit, eines zweiten Stromwerts mittels der zweiten Stromermittlungseinheit, eines dritten Stromwerts mittels der dritten Stromermittlungseinheit und eines vierten Stromwerts mittels der vierten Stromermittlungseinheit, wenn der elektrische Widerstand mit dem ersten Anschluss des zweiten Energiespeichers elektrisch gekoppelt ist. Darüber hinaus erfolgt ein Ermitteln eines, einen Innenwiderstand des zweiten Energiespeichers kennzeichnenden Widerstandswerts basierend auf dem ermittelten ersten Spannungswert und dem ermittelten zweiten Spannungswert sowie ein Klassifizieren des ermittelten Widerstandswerts basierend auf den ermittelten ersten, zweiten, dritten und vierten Stromwerten.

Das Fahrzeug und das Verfahren gemäß den genannten Aspekten der Erfindung weisen die bereits im Zusammenhang mit den entsprechenden Bordnetzen genannten Vorteile auf, welche an dieser Stelle zur Vermeidung von Wiederholungen nicht nochmals aufgeführt werden.

In einer Ausführungsform des Verfahrens beinhaltet das Klassifizieren des ermittelten Widerstandswerts ein Vergleichen jeweils der vor und nach dem Schließen der dritten Schaltvorrichtung ermittelten ersten Stromwerte, der vor und nach dem Schließen der dritten Schaltvorrichtung ermittelten zweiten Stromwerte, der vor und nach dem Schließen der dritten Schaltvorrichtung ermittelten dritten Stromwerte und der vor und nach dem Schließen der dritten Schaltvorrichtung ermittelten vierten Stromwerte miteinander.

In einer weiteren Ausführungsform des Verfahrens erfolgt das Klassifizieren des ermittelten Widerstandswerts zudem basierend auf dem ermittelten ersten Spannungswert und dem ermittelten zweiten Spannungswert. Dies ermöglicht in vorteilhafter Weise eine weiter verbesserte Plausibilisierung des ermittelten, den Innenwiderstand des zweiten Energiespeichers kennzeichnenden Widerstandswerts.

In einer weiteren Ausführungsform des Verfahrens erfolgt zudem eine Zeitermittlung, nachdem die dritte Schaltvorrichtung geschlossen wurde. In der genannten Ausgestaltung erfolgt das Ermitteln des zweiten Spannungswerts nach einer vorbestimmten Zeitdauer nach dem Beginn der Zeitermittlung.

Nach dem Schließen der dritten Schaltvorrichtung kann die Spannung des zweiten Energiespeichers wiederholt ermittelt werden. In der genannten Ausgestaltung wird der zweite Spannungswert ermittelt, wenn eine Abweichung von aufeinanderfolgend ermittelten Werten der Spannung voneinander einen vorbestimmten Schwellenwert unterschreitet. Dadurch kann die Ermittlung des zweiten Spannungswerts erfolgen, nachdem sich die Spannung nach dem Schließen der dritten Schaltvorrichtung stabilisiert hat und somit ein besonders geeigneter Messzeitpunkt bereitgestellt werden.

In einer weiteren Ausführungsform des Verfahrens erfolgt zudem nach dem Ermitteln des den Innenwiderstand des zweiten Energiespeichers kennzeichnenden Widerstandswerts ein Öffnen der dritten Schaltvorrichtung. Ferner erfolgt ein Ermitteln eines dritten Spannungswerts der Spannung des zweiten Energiespeichers und ein wiederholtes Ermitteln eines ersten Stromwerts mittels der ersten Stromermittlungseinheit, eines zweiten Stromwerts mittels der zweiten Stromermittlungseinheit, eines dritten Stromwerts mittels der dritten Stromermittlungseinheit und eines vierten Stromwerts mittels der vierten Stromermittlungseinheit, wenn der elektrische Widerstand von dem ersten Anschluss des zweiten Energiespeichers elektrisch getrennt ist. Das Klassifizieren des ermittelten Widerstandswerts erfolgt in der genannten Ausführungsform zudem basierend auf dem ermittelten dritten Spannungswert und den ermittelten ersten, zweiten, dritten und vierten Stromwerten, die ermittelt werden, wenn der elektrische Widerstand von dem ersten Anschluss des zweiten Energiespeichers elektrisch getrennt ist. Dies ermöglicht eine weiter verbesserte Plausibilisierung des ermittelten, den Innenwiderstand des zweiten Energiespeichers kennzeichnenden Widerstandswerts.

Ausführungsformen der Erfindung werden nun anhand der beigefügten Figuren näher erläutert.

Figur 1A     zeigt ein Blockschaltbild eines Bordnetzes gemäß einer ersten Ausführungsform der Erfindung;

Figur 1B     zeigt ein Blockschaltbild eines Bordnetzes gemäß einer zweiten Ausführungsform der Erfindung;

Figur 2     zeigt ein Blockschaltbild eines Bordnetzes gemäß einer dritten Ausführungsform der Erfindung;

Figur 3     zeigt ein Blockschaltbild des in den Figuren 1A bis 2 gezeigten Moduls gemäß einer Ausführungsform;

Figur 4     zeigt ein Prinzipschaltbild von Bordnetzen gemäß der Erfindung;

Figur 5     zeigt ein Beispiel einer Konfigurationsmöglichkeit der Dauer des geschlossenen Zustands der in Figur 3 gezeigten dritten Schaltvorrichtung.

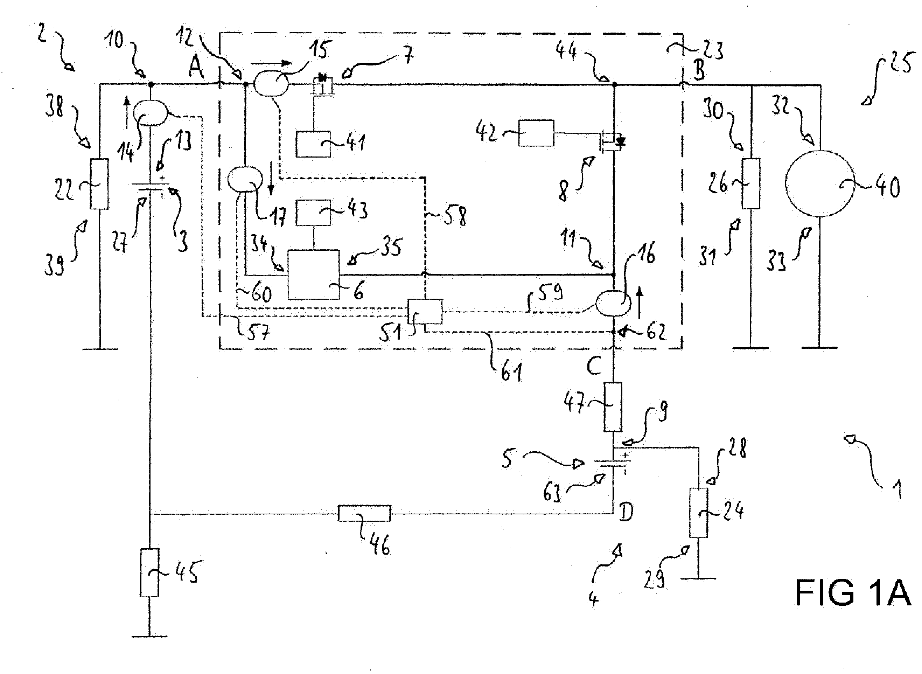

Figur 1A zeigt ein Blockschaltbild eines Bordnetzes 1 eines nicht näher dargestellten Fahrzeugs gemäß einer ersten Ausführungsform der Erfindung. Das Bordnetz 1 kann beispielsweise Bestandteil eines Kraftfahrzeugs, insbesondere eines Personenkraftwagens oder eines Lastkraftwagens, sein.

Das Bordnetz 1 weist einen ersten Bordnetzzweig 2 mit einer ersten Nominalspannung $U_1$, die auch als Vsys1 bezeichnet werden kann, auf, wobei der erste Bordnetzzweig 2 einen ersten elektrischen Energiespeicher 3 und einen ersten elektrischen Verbraucher 22 aufweist. Der erste elektrische Energiespeicher 3 ist in der gezeigten Ausführungsform als 12-Volt-Akkumulator, beispielsweise als 12-Volt-Li-Ionen-Akkumulator, ausgebildet. Der erste elektrische Verbraucher 22 bildet eine dynamische Last und kann beispielsweise als Starter eines nicht näher dargestellten Verbrennungsmotors des Fahrzeugs ausgebildet sein.

Zudem weist das Bordnetz 1 einen zweiten Bordnetzzweig 4 mit einer zweiten Nominalspannung $U_2$, die auch als Vsys2 bezeichnet werden kann, auf. Der zweite Bordnetzzweig 4 weist in der gezeigten Ausführungsform einen zweiten elektrischen Energiespeicher 5 sowie einen zweiten elektrischen Verbraucher 24 auf. Der zweite elektrische Energiespeicher 5 ist beispielsweise wiederum als 12-Volt-Akkumulator, insbesondere als 12-Volt-Li-Ionen-Akkumulator, oder als 12-Volt-Kondensatoranordnung ausgebildet. Der zweite elektrische Verbraucher 24 wird beispielsweise durch Sensoren für die Diagnose des Systems gebildet.

Ferner weist das Bordnetz 1 in der gezeigten Ausführungsform einen dritten Bordnetzzweig 25 mit einer dritten Nominalspannung $U_3$, die auch als Vsys3 bezeichnet wird, auf. Der dritte Bordnetzzweig 25 weist einen dritten elektrischen Verbraucher 26 auf, der eine dynamische Last, beispielsweise eine elektrische Lenkung, bildet. Darüber hinaus weist das Bordnetz 1 einen Generator 40 auf, der in der gezeigten Ausführungsform Bestandteil des dritten Bordnetzzweigs 25 ist. Der Generator 40 ist über eine nicht näher dargestellte mechanische Kopplung, beispielsweise einen Keilrippenriemen, mit dem Verbrennungsmotor des Fahrzeugs verbunden.

Der erste Bordnetzzweig 2, der zweite Bordnetzzweig 4 und der dritte Bordnetzzweig 25 weisen in der gezeigten Ausführungsform die gleiche Nominalspannung auf, das heißt Vsys1 = Vsys2 = Vsys3.In der gezeigten Ausführungsform beträgt die Nominalspannung 12 V. Ferner kann die Nominalspannung 14 V oder insbesondere bei Lastkraftwagen 24 V oder 48 V betragen.

Das Bordnetz 1 weist weiterhin einen DC/DC-Wandler 6 auf, der als bidirektionaler Gleichspannungswandler ausgebildet ist und insbesondere eine erste elektrische Spannung in eine zweite elektrische Spannung und umgekehrt umwandeln kann. Dazu ist der DC/DC-Wandler 6 in der gezeigten Ausführungsform als Synchronwandler zum bidirektionalen Übertragen von Energie zwischen dem ersten Bordnetzzweig 2 und dem zweiten Bordnetzzweig 4 ausgebildet.

Ferner weist das Bordnetz 1 eine erste Schaltvorrichtung 7 und eine zweite Schaltvorrichtung 8 auf, wobei die erste Schaltvorrichtung 7 und die zweite Schaltvorrichtung 8 in der gezeigten Ausführungsform als Halbleiterschalter in Form von normal sperrenden n-Kanal-MOSFET-Schaltern ausgebildet sind. Die einem MOSFET inhärente Bodydiode ermöglicht dabei in vorteilhafter Weise eine weitere Redundanz insbesondere der ersten Schaltvorrichtung 7 und verhindert eine ungewünschte Entladung des zweiten elektrischen Energiespeicher 5 in den ersten Bordnetzzweig 2 bzw. den dritten Bordnetzzweig 25. In einer weiteren Ausgestaltung können die erste Schaltvorrichtung 7 und/oder die zweite Schaltvorrichtung 8 als Halbleiterschalter in Form von IGBT-Schaltern oder als Relais ausgebildet sein.

Die erste Schaltvorrichtung 7 ist auf einer ersten Kontaktseite, d.h. in der gezeigten Ausführungsform sourceseitig, über einen ersten Knotenpunkt 10 und einen dritten Knotenpunkt 12 mit einem ersten Anschluss 13 des ersten elektrischen Energiespeichers 3 und einem ersten Anschluss 38 des ersten elektrischen Verbrauchers 22 verbunden. Ferner ist die erste Schaltvorrichtung 7 sourceseitig über den dritten Knotenpunkt 12 mit einem ersten Anschluss 34 des DC/DC-Wandlers 6 verbunden.

Auf einer zweiten Kontaktseite, d.h. in der gezeigten Ausführungsform drainseitig, ist die erste Schaltvorrichtung 7 über einen vierten Knotenpunkt 44 mit einer ersten Kontaktseite der zweiten Schaltvorrichtung 8, d.h. in der gezeigten Ausführungsform der Sourceseite der zweiten Schaltvorrichtung 8 und mit einem ersten Anschluss 30 des dritten elektrischen Verbrauchers 26 sowie einem ersten Anschluss 32 des Generators 40 verbunden.

Die zweite Schaltvorrichtung 8 ist auf einer zweiten Kontaktseite, d.h. in der gezeigten Ausführungsform drainseitig, über einen zweiten Knotenpunkt 11 mit einem zweiten Anschluss 35 des DC/DC-Wandlers 6 sowie einem ersten Anschluss 9 des zweiten elektrischen Energiespeichers 5 und einem ersten Anschluss 28 des zweiten elektrischen Verbrauchers 24 verbunden. Sourceseitig ist die zweite Schaltvorrichtung 8 ferner über den vierten Knotenpunkt 44 mit dem ersten Anschluss 30 des dritten elektrischen Verbrauchers 26 sowie dem ersten Anschluss 32 des Generators 40 verbunden.

Ein zweiter Anschluss 27 des ersten elektrischen Energiespeichers 3, ein zweiter Anschluss 39 des ersten elektrischen Verbrauchers 4, ein zweiter Anschluss 63 des zweiten elektrischen Energiespeichers 5 sowie ein zweiter Anschluss 29 des zweiten elektrischen Verbrauchers 24 sind mit einem Bezugspotential in Form eines Massepotentials elektrisch gekoppelt. Weiterhin sind ein zweiter Anschluss 31 des dritten elektrischen Verbrauchers 26 sowie ein zweiter Anschluss 33 des Generators 40 mit dem Bezugspotential elektrisch gekoppelt.

Sourceseitig der ersten Schaltvorrichtung 7 ist ein Pol A eines Vierpols ausgebildet. Weiterhin ist sourceseitig der zweiten Schaltvorrichtung 8 ein Pol B und drainseitig der zweiten Schaltvorrichtung 8 ein Pol C des Vierpols ausgebildet. Ein Pol D des Vierpols wird durch das Bezugspotential gebildet.

Der erste Anschluss 9 des zweiten elektrischen Energiespeichers 5 ist in einem geschlossenen Schaltzustand der ersten Schaltvorrichtung 7 und einem gleichzeitig geschlossenen Schaltzustand der zweiten Schaltvorrichtung 8, das heißt in der gezeigten Ausführungsform bei Anlegen einer Steuerspannung in Form einer entsprechenden differentiellen Gate-Source-Spannung an das Gate des jeweiligen n-Kanal-MOSFETs, bei der ein elektrisch leitender Kanal ausgebildet wird, über den ersten Knotenpunkt 10, den zweiten Knotenpunkt 11 und den dritten Knotenpunkt 12 mit dem ersten Bordnetzzweig 2 elektrisch gekoppelt. Der erste Anschluss 9 des zweiten elektrischen Energiespeichers 5 ist dabei mit dem Pluspfad des ersten Bordnetzzweigs 2, das heißt dem ersten Anschluss 13 des ersten elektrischen Energiespeichers 3 und dem ersten Anschluss 38 des ersten elektrischen Verbrauchers 22, elektrisch gekoppelt.

In einem geöffneten Schaltzustand der ersten Schaltvorrichtung 7 und einem gleichzeitig geöffneten Schaltzustand der zweiten Schaltvorrichtung 8, das heißt bei Anlegen einer differentiellen Gate-Source-Spannung an das Gate der n-Kanal-MOSFETs, bei der kein elektrisch leitender Kanal ausgebildet wird, und bei gleichzeitig deaktiviertem bzw. inaktiven DC/DC-Wandler 6 ist der erste Anschluss 9 von dem ersten Bordnetzzweig 2 elektrisch getrennt. Ist lediglich eine der beiden Schaltvorrichtungen 7 und 8 geöffnet und die jeweils andere geschlossen sowie zudem der DC/DC-Wandler 6 deaktiviert, ist der erste Anschluss 9 des zweiten elektrischen Energiespeichers 5 in der gezeigten Ausführungsform ebenfalls von dem ersten Bordnetzzweig 2 elektrisch getrennt.

Das Bordnetz 1 weist in der gezeigten Ausführungsform zudem eine erste Ansteuereinheit 41, die zum Ansteuern der ersten Schaltvorrichtung 7 ausgebildet ist, sowie eine zweite Ansteuereinheit 42, die zum Ansteuern der zweiten Schaltvorrichtung 8 ausgebildet ist, und eine dritte Ansteuereinheit 43, die zum Ansteuern des DC/DC-Wandlers 6 ausgebildet ist, auf. Die erste Ansteuereinheit 41, die zweite Ansteuereinheit 42 und die dritte Ansteuereinheit 43 können dabei zumindest teilweise monolithisch integriert sein.

Mittels der dritten Ansteuereinheit 43 kann insbesondere die Richtung eines Energieübertrags zwischen dem ersten Bordnetzzweig 2 und dem zweiten Bordnetzzweig 4 über den DC/DC-Wandler 6 festgelegt werden. Weiterhin kann damit der Regelbetrieb des DC/DC-Wandlers 6 festgelegt werden, das heißt, es kann bestimmt werden, ob der DC/DC-Wandler 6 spannungsgeregelt, stromgeregelt oder leistungsgeregelt betrieben wird. Zudem können die erste Ansteuereinheit 41, die zweite Ansteuereinheit 42 und/oder die dritte Ansteuereinheit 43 mit weiteren, nicht näher dargestellten Fahrzeugkomponenten, insbesondere weiteren Steuereinheiten des Fahrzeugs gekoppelt sein, um in Abhängigkeit eines jeweiligen Betriebszustands des Fahrzeugs Ansteuersignale zum Ansteuern der ersten Schaltvorrichtung 7, der zweiten Schaltvorrichtung 8 und des DC/DC-Wandlers 6 zu erzeugen.

Weiterhin weist das Bordnetz 1 eine erste Stromermittlungseinheit 14 auf, die zum Ermitteln eines ersten Stromwerts eines zwischen dem ersten Anschluss 13 des ersten Energiespeichers 3 und dem ersten Knotenpunkt 10 fließenden, schematisch mittels eines Pfeils dargestellten ersten Stroms ausgebildet ist. Zudem weist das Bordnetz 1 eine zweite Stromermittlungseinheit 15 auf, die zum Ermitteln eines zweiten Stromwerts eines über die erste Schaltvorrichtung 7 und die zweite Schaltvorrichtung 8 fließenden, schematisch mittels eines Pfeils dargestellten zweiten Stroms ausgebildet ist. Weiterhin weist das Bordnetz 1 eine dritte Stromermittlungseinheit 16 auf, die zum Ermitteln eines dritten Stromwerts eines zwischen dem ersten Anschluss 9 des zweiten Energiespeichers 5 und dem zweiten Knotenpunkt 11 fließenden dritten, schematisch mittels eines Pfeils dargestellten Stroms ausgebildet ist. Darüber hinaus weist das Bordnetz 1 eine vierte Stromermittlungseinheit 17 auf, die zum Ermitteln eines vierten Stromwerts eines zwischen dem dritten Knotenpunkt 12 und dem DC/DC-Wandler 6 fließenden vierten, schematisch mittels eines Pfeils dargestellten Stroms ausgebildet ist. Die erste Stromermittlungseinheit 14, die zweite Stromermittlungseinheit 15, die dritte Stromermittlungseinheit 16 und die vierte Stromermittlungseinheit 17 sind beispielsweise als Stromsensoren, insbesondere als Hallelement, oder als Shunt ausgebildet.

Ferner weist das Bordnetz 1 ein Modul 51 auf. Das Modul 51 weist einen in Figur 1A nicht näher dargestellten elektrischen Widerstand auf, wobei der elektrische Widerstand mittels einer in Figur 1A ebenfalls nicht näher dargestellten dritten Schaltvorrichtung mit dem ersten Anschluss 9 des zweiten Energiespeichers 5 elektrisch koppelbar ist. Darüber hinaus weist das Modul 51 eine in Figur 1A nicht näher dargestellte Spannungsermittlungseinheit auf, wobei die Spannungsermittlungseinheit ausgebildet ist zum Ermitteln eines ersten Spannungswerts einer Spannung des zweiten Energiespeichers 5, wenn der elektrische Widerstand von dem ersten Anschluss 9 des zweiten Energiespeichers 5 elektrisch getrennt ist. Ferner ist die Spannungsermittlungseinheit ausgebildet zum Ermitteln eines zweiten Spannungswerts der Spannung des zweiten Energiespeichers 5, wenn der elektrische Widerstand mit dem ersten Anschluss 9 des zweiten Energiespeichers 5 elektrisch gekoppelt ist. Zudem weist das Modul 51 eine in Figur 1A nicht näher dargestellten Innenwiderstands-Ermittlungseinheit auf, wobei die Innenwiderstands-Ermittlungseinheit ausgebildet ist zum Ermitteln eines, einen Innenwiderstand des zweiten Energiespeichers 5 kennzeichnenden Widerstandswerts basierend auf dem ermittelten ersten Spannungswert und dem ermittelten zweiten Spannungswert und zum Klassifizieren des ermittelten Widerstandswerts basierend auf den ermittelten ersten, zweiten, dritten und vierten Stromwerten.

Dazu ist das Modul 51 über eine Signalleitung 57 mit der ersten Stromermittlungseinheit 14 verbunden. Ferner ist das Modul 51 über eine Signalleitung 58 mit der zweiten Stromermittlungseinheit 15, über eine Signalleitung 59 mit der dritten Stromermittlungseinheit 16 und über eine Signalleitung 60 mit der vierten Stromermittlungseinheit 17 verbunden. Darüber hinaus ist das Modul 51 über eine Messleitung 61 mit einem Spannungsabgriff 62 im Bereich des ersten Anschlusses 9 des zweiten Energiespeichers 5 verbunden.

Mittels der gezeigten Ausführungsform der Erfindung wird die Bestimmung des statischen Innenwiderstands, welcher auch als statischer ESR (Ersatzserienwiderstand bei Kondensatoren) bezeichnet wird, des zweiten Energiespeichers 5 insbesondere mittels einer monolithisch integrierten Schaltung ermöglicht. Dadurch kann durch Erfassung einer erweiterten Anzahl von Systemparametern und deren Speicherung auch bei ungünstigen Systemverhältnissen, beispielsweise einem Abriss oder Nichtvorhandensein von Fühlerleitungen oder einem beliebigen dynamischen Spannungsoffset innerhalb des Systems eine höhere Genauigkeit der Bestimmung durch das Bereitstellen von Kriterien für ungültige bzw. gültige Messungen ermöglicht werden. Der Innenwiderstand eines Energiespeichers ist dabei typischerweise ein besonders geeignetes Mittel zur Einschätzung dessen Verfügbarkeit bzw. Restlebensdauer.

Der elektrische Widerstand weist in der gezeigten Ausführungsform einen vorbestimmten bzw. vorgegebenen Widerstandswert auf. Dieser kann beispielsweise als konstante Größe in einem Algorithmus zur Berechnung abgelegt werden, wobei der abgelegte Widerstandswert bereits mögliche Toleranzen, insbesondere aufgrund von Alterung und/oder Temperaturschwankungen, beinhaltet. Da der Widerstandswert des elektrischen Widerstand somit bekannt ist, kann die Summe aus dem Innenwiderstand des zweiten Energiespeichers 5 sowie der Zuleitungswiderstände zu dem zweiten Energiespeicher 5 bis zu den Messpunkten ermittelt werden, wie im Folgenden näher erläutert wird.

Bei Annahme einer idealen Verbindung des Moduls 51 zu den Polen C und D des Vierpols ergibt sich der Innenwiderstand $R_{BAT\_ES2}$ des zweiten Energiespeichers 5 aus der folgenden Gleichung:

$$R_{BAT\_ES2} = (U_{PRE} \; / \; U_{ADD} \; -1) \cdot R_{ADD},$$

wobei $R_{ADD}$ der Widerstandswert des elektrischen Widerstands, $U_{PRE}$ die Spannung des zweiten Energiespeichers 5, wenn der elektrische Widerstand von dem ersten Anschluss 9 des zweiten Energiespeichers 5 elektrisch getrennt ist, d.h. bei geöffneter dritter Schaltvorrichtung vor Aufschalten des elektrischen Widerstands, und $U_{ADD}$ die Spannung des zweiten Energiespeichers 5, wenn der elektrische Widerstand mit dem ersten Anschluss 9 des zweiten Energiespeichers 5 elektrisch gekoppelt ist, d.h. bei geschlossener dritter Schaltvorrichtung während des Aufschaltens des elektrischen Widerstands ist.

Im realen System sind diese Verhältnisse typischerweise nicht gegeben. So ist beispielsweise der Pol D nicht mittels einer eigenen Fühlerleitung erreichbar und es treten Verkabelungs- bzw. Leitungswiderstände sowie Übergangsbzw. Kontaktierungswiderstände an Verbindungspunkten auf, die in der Größenordnung des zu messenden Widerstandes oder sogar höher liegen können. Figur 1A zeigt eine Systemanordnung, bei welcher der zweite Energiespeicher 5 nicht optimal angeschlossen werden kann. Dabei sind in Figur 1A beispielhaft Verkabelungs- bzw. Leitungswiderstände sowie Übergangs- bzw. Kontaktierungswiderstände an Verbindungspunkten schematisch mittels eines ersten elektrischen Widerstands 45, welcher auch als $R_{HAR1}$ bezeichnet wird, eines zweiten elektrischen Widerstands 46, welcher auch als $R_{HAR2}$ bezeichnet wird und eines dritten elektrischen Widerstands 47, welcher auch als $R_{HAR3}$ bezeichnet wird, dargestellt. Die elektrischen Widerstände 45, 46, und 47 stellen somit im Gegensatz zu dem oben genannten elektrischen Widerstand parasitäre Komponenten des Bornetzes 1 dar.

Somit ergibt sich für diesen Betrachtungsfall ein Messergebnis von $R_{BAT\_ES2}$ = ESR + $R_{HAR1}$ + $R_{HAR2}$ + $R_{HAR3}$, wobei ESR den Innenwiderstand des zweiten Energiespeichers 5 angibt. Der Widerstandswert $R_{BAT\_ES2}$ stellt somit einen, den Innenwiderstand des zweiten Energiespeichers 5 kennzeichnenden Widerstandswert dar, welcher von dem Innenwiderstand des zweiten Energiespeichers 5 um die auftretenden Verkabelungs- bzw. Leitungswiderstände sowie Übergangs- bzw. Kontaktierungswiderstände abweicht.

Durch Kenntnis der zusätzlichen Strommesswerte in dem System ergibt sich die Möglichkeit, die Messergebnisse zu plausibilisieren. Daraus ergibt sich die Möglichkeit, durch zeitgleiche Parametererfassung bzw. Messung sowie Speicherung dieser Parameter bei unabhängigen System- und Fahrzeugzuständen bzw. bei wesentlich mehr Betriebszuständen valide Diagnoseinformationen zu ermitteln. Dies ermöglicht Vorteile bei sicherheitsrelevanten Anwendungen, da der zweite Energiespeicher 5 als Systemenergiespeicher-Backup bzw. Systemenergiespeicher-Unterstützung dienen kann. Ferner kann die Systemverfügbarkeit bei verschiedenen Betriebszuständen diagnostiziert bzw. vorausberechnet werden.

Ferner besteht die Möglichkeit der Variation des Belastungswiderstandes $R_{ADD}$ für eine optimale Anpassung des Differenz-Spannungsmesswerts und die Limitierung der Verlustleistung in der Anordnung.

Eine Strommessung durch den Belastungswiderstand $R_{ADD}$ ist dabei nicht unmittelbar erforderlich. Anstelle der direkten Messstromermittlung tritt in der gezeigten Ausführungsform die Erfassung der Systemströme, d.h. der ersten, zweiten, dritten und vierten Stromwerte insbesondere für die Plausibilisierung und Bewertung des ermittelten, den Innenwiderstand des zweiten Energiespeichers 5 kennzeichnenden Widerstandswerts $R_{BAT\_ES2}$ durch das Modul 51.

Durch Aufschaltung einer definierten Last $R_{ADD}$ kann der Mess-Zeitpunkt bei unterschiedlichen Systemzuständen gewählt werden, beispielsweise bei einem Fahren, Rollen bzw. Stehen des Fahrzeugs, einem Motorstart, einem Laden oder Entladen der Energiespeicher.

Eine Plausibilisierung und Bewertung des ermittelten, den Innenwiderstand des zweiten Energiespeichers 5 kennzeichnenden Widerstandswerts $R_{BAT\_ES2}$ durch das Modul 51 erfolgt in der gezeigten Ausführungsform wie folgt. Falls zumindest einer der während des Aufschaltens des elektrischen Widerstands ermittelten Stromstärkewerte, d.h. zumindest einer der ermittelten ersten, zweiten, dritten und vierten Stromwerte, wenn der elektrische Widerstand mit dem ersten Anschluss 9 des zweiten Energiespeichers 5 elektrisch gekoppelt ist, stark unterschiedlich zu dem entsprechenden vor dem Aufschalten des elektrischen Widerstands oder nach dem erneuten Trennen des elektrischen Widerstands ermittelten Stromstärkewert, d.h. dem entsprechenden, bei geöffneter dritter Schaltvorrichtung ermittelten ersten, zweiten, dritten bzw. vierten Stromwert, ist und somit ein Stromsprung an zumindest einem der Strommesspunkte auftritt, ist dies ein Kriterium, den ermittelten Wert $R_{BAT\_ES2}$ zu verwerfen, beispielsweise falls der Stromsprung über einer bestimmten Grenze ist, d.h. die Differenz zwischen vor dem Aufschalten des elektrischen Widerstands bzw. nach dem erneuten Trennen des elektrischen Widerstands ermittelten Stromstärkewerten und während des Aufschaltens des elektrischen Widerstands ermittelten Stromstärkewerten einen vorbestimmten Schwellenwert überschreitet.

Darüber hinaus kann das Klassifizieren des ermittelten Widerstandswerts zudem basierend auf dem ermittelten ersten Spannungswert, dem ermittelten zweiten Spannungswert und dem ermittelten dritten Spannungswert erfolgen. Beispielsweise kann der ermittelte Widerstandswert verworfen werden, falls die Differenz zwischen der vor dem Aufschalten des elektrischen Widerstands ermittelten Spannung des zweiten Energiespeichers 5 und der während des Aufschaltens des elektrischen Widerstands ermittelten Spannung und/oder die Differenz zwischen der während des Aufschaltens des elektrischen Widerstands ermittelten Spannung des zweiten Energiespeichers 5 und der nach dem erneuten Trennen des elektrischen Widerstands ermittelten Spannung einen ersten vorbestimmten Schwellenwert überschreitet oder zumindest eine der ermittelten Spannungen um einen zweiten vorbestimmten Schwellenwert von der Nominalspannung des zweiten Bordnetzzweigs 4 abweicht.

Die Messung ist dabei unabhängig von externen Lastwiderständen und damit beispielsweise auch bei aktiviertem DC/DC-Wandler 6 durchführbar.

Dieses Messprinzip kann sowohl auf den ersten Energiespeicher 3, den zweiten Energiespeicher 5 und einen optional in dem dritten Bordnetzzweig 25 angeordneten, in Figur 1A nicht dargestellten dritten Energiespeicher angewendet werden.

Bei Vorhandensein einer Fühlerleitung von dem Modul 51 zu dem Pol D können durch zwei aufeinanderfolgende Spannungsmessungen (zwischen Pol C und Pol D und anschließend zwischen Pol C und dem Bezugspotential) die Werte von $R_{HAR1}$ und $R_{HAR2}$ ermittelt und somit deren Einfluss bei der Messung des Innenwiderstandes des zweiten Energiespeichers 5 herausgerechnet werden.

Das gewählte Messsystem ist dabei in vorteilhafter Weise unabhängig von der verwendeten Technologie der Energiespeicher. Zudem kann eine Innenwiderstands-Ermittlung beispielsweise während eines Anlassvorgangs (Cranking), bei aktiviertem DC/DC-Wandler 6, einem Übergang von einem Hochenergiemodus (HPM, High Power Mode) zu einem Niedrigenergiemodus (LPM, Low Power Mode) oder umgekehrt stattfinden.

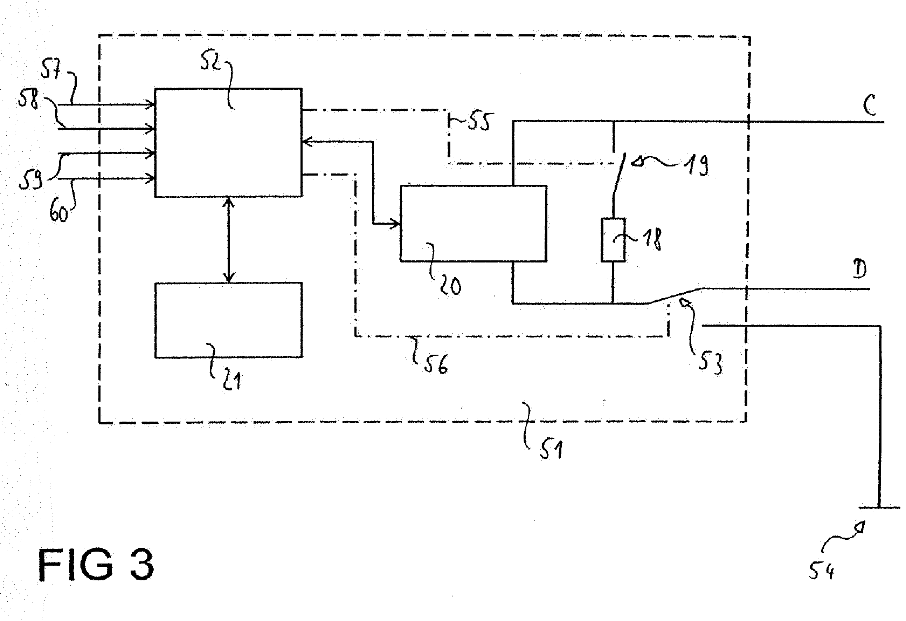

Der elektrische Widerstand, die dritte Schaltvorrichtung, die Spannungsermittlungseinheit sowie die Innenwiderstands-Ermittlungseinheit werden ferner im Zusammenhang mit Figur 3 weiter erläutert.

In der gezeigten Ausführungsform sind der DC/DC-Wandler 6, die erste Schaltvorrichtung 7, die zweite Schaltvorrichtung 8, die dritte Schaltvorrichtung, der elektrische Widerstand, die Innenwiderstands-Ermittlungseinheit, die erste Ansteuereinheit 41, die zweite Ansteuereinheit 42 und die dritte Ansteuereinheit 43 Bestandteil einer Steuereinheit 23, die auch als Control Unit (CU) bezeichnet wird. Die Control Unit steuert bzw. regelt die Energieflüsse innerhalb des Gesamtsystems.

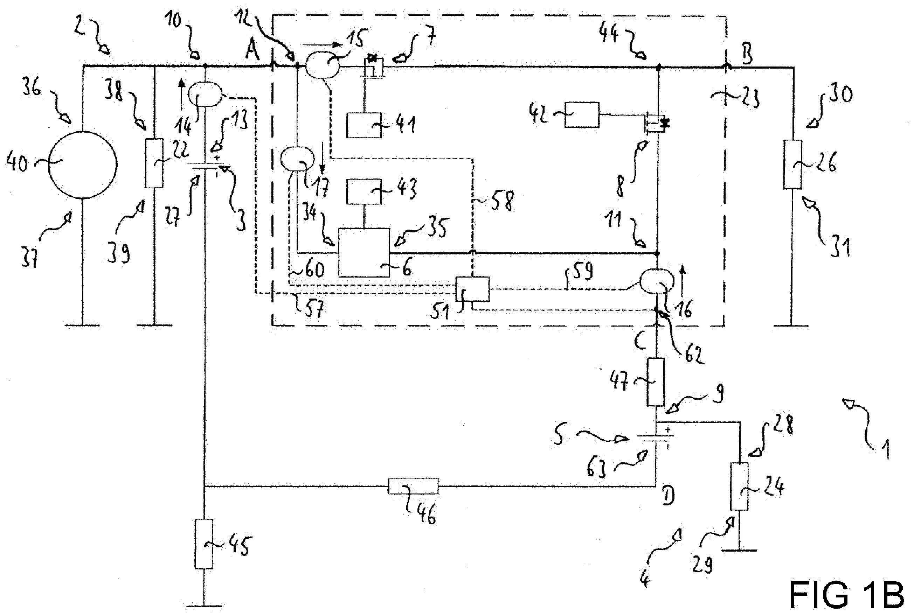

Figur 1B zeigt ein Blockschaltbild eines Bordnetzes 1 eines nicht näher dargestellten Fahrzeugs gemäß einer zweiten Ausführungsform der Erfindung. Komponenten mit den gleichen Funktionen wie in Figur 1A werden mit den gleichen Bezugszeichen gekennzeichnet und im Folgenden nicht nochmals erläutert.

Das Bordnetz 1 gemäß Figur 1B unterscheidet sich von der in Figur 1A gezeigten Ausführungsform dadurch, dass der Generator 40 Bestandteil des ersten Bordnetzzweigs 2 ist. Damit ist in der gezeigten Ausführungsform die erste Schaltvorrichtung 7 sourceseitig mit einem ersten Anschluss 36 des Generators 40, dem ersten Anschluss 38 des ersten elektrischen Verbrauchers 22 und dem ersten Anschluss 13 des ersten elektrischen Energiespeichers 3 verbunden. Die zweite Schaltvorrichtung 8 ist in der gezeigten Ausführungsform sourceseitig mit dem ersten Anschluss 30 des dritten elektrischen Verbrauchers 26 sowie der Drainseite der ersten Schaltvorrichtung 7 verbunden. Ein zweiter Anschluss 37 des Generators 40 ist mit dem Bezugspotential elektrisch gekoppelt.

Das Ermitteln eines, einen Innenwiderstand des zweiten Energiespeichers 5 kennzeichnenden Widerstandswerts basierend auf einem ermittelten ersten Spannungswert und einem ermittelten zweiten Spannungswert sowie das Klassifizieren des ermittelten Widerstandswerts basierend auf ermittelten ersten, zweiten, dritten und vierten Stromwerten erfolgt entsprechend der in Figur 1A erläuterten Weise.

Die in den Figuren 1A und 1B gezeigten Bordnetz-Topologien werden dabei auch als DBM (Dual Battery Management) bezeichnet.

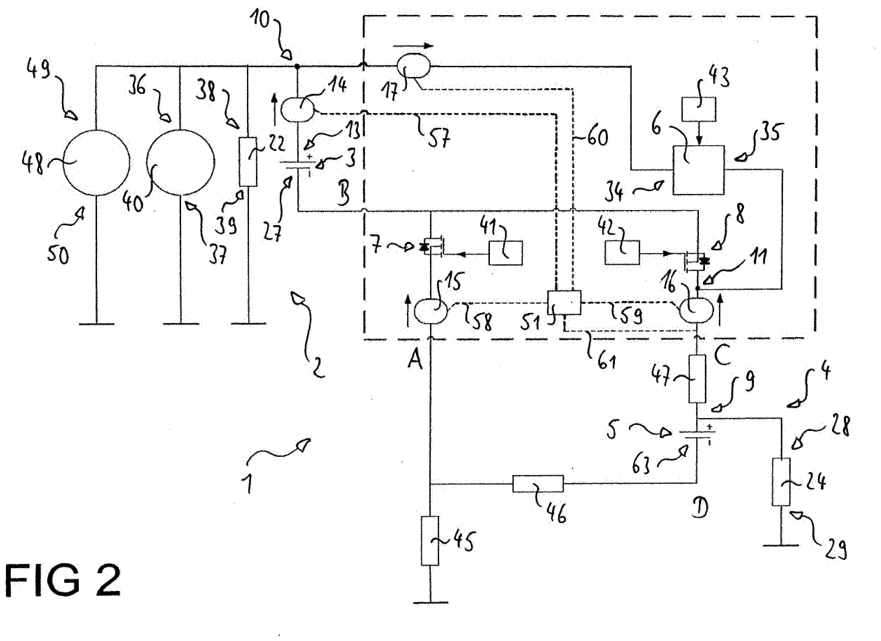

Figur 2 zeigt ein Blockschaltbild eines Bordnetzes 1 eines nicht näher dargestellten Fahrzeugs gemäß einer dritten Ausführungsform der Erfindung. Komponenten mit den gleichen Funktionen wie in den Figuren 1A und 1B werden mit den gleichen Bezugszeichen gekennzeichnet und im Folgenden nicht nochmals erläutert.

Die in Figur 2 gezeigte Bordnetz-Topologie wird dabei auch als VSS (Voltage Stabilization System) bezeichnet und unterscheidet sich von den in den Figuren 1A und 1B gezeigten Ausführungsformen dadurch, dass der zweite Anschluss 27 des ersten elektrischen Energiespeichers 3 mit der Drainseite der ersten Schaltvorrichtung 7 sowie der Sourceseite der zweiten Schaltvorrichtung 8 elektrisch verbunden ist. Ferner ist die erste Schaltvorrichtung 7 sourceseitig mit dem Bezugspotential gekoppelt.

Der erste Anschluss 9 des zweiten elektrischen Energiespeichers 5 ist dabei über den ersten Knotenpunkt 10, den zweiten Knotenpunkt 11 und den DC/DC-Wandlers 6 mit dem ersten Anschluss 13 des ersten Energiespeichers 3 elektrisch koppelbar. Ferner ist der erste Anschluss 11 des zweiten elektrischen Energiespeichers 6 in einem geschlossenen Schaltzustand der ersten Schaltvorrichtung 7 und einem geschlossenen Schaltzustand der zweiten Schaltvorrichtung 8 mit dem Bezugspotential elektrisch gekoppelt und in einem geöffneten Schaltzustand der ersten Schaltvorrichtung 7 und einem geöffneten Schaltzustand der zweiten Schaltvorrichtung 8 von dem Bezugspotential elektrisch getrennt. Unabhängig von dem Schaltzustand der ersten Schaltvorrichtung 7 ist der erste Anschluss 9 des zweiten elektrischen Energiespeichers 5 bei geschlossenem Schaltzustand der zweiten Schaltvorrichtung 8 mit dem zweiten Anschluss 27 des ersten elektrischen Energiespeichers 3 elektrisch gekoppelt. Der erste elektrische Energiespeicher 3 und der zweite elektrische Energiespeicher 5 können somit bei geschlossener zweiter Schaltvorrichtung 8 und gleichzeitig geöffneter erster Schaltvorrichtung 7 elektrisch in Serie geschaltet werden.

Das Bordnetz 1 weist in der gezeigten Ausführungsform lediglich zwei Bordnetzzweige in Form des ersten Bordnetzzweigs 2 und des zweiten Bordnetzzweigs 4 auf. Weiterhin weist das Bordnetz 1 in der gezeigten Ausführungsform einen Starter 48 auf, der beispielsweise als Ritzelstarter ausgebildet und Bestandteil des ersten Bordnetzzweigs 2 ist, wobei ein erster Anschluss 49 des Starters 48 mit dem Pluspfad des ersten Bordnetzzweigs 2 verbunden und ein zweiter Anschluss 50 des Starters 48 mit dem Bezugspotential gekoppelt ist. Der Generator 40 ist in der gezeigten Ausführungsform als Startergenerator ausgebildet und ebenfalls Bestandteil des ersten Bordnetzzweigs 2.

Der erste Bordnetzzweig 2 weist in der gezeigten Ausführungsform eine Nominalspannung auf, die größer ist als die Nominalspannung des zweiten Bordnetzzweigs 4, das heißt Vsys1 > Vsys2. Beispielsweise beträgt die Nominalspannung Vsys1 12 V oder 14 V und die Nominalspannung Vsys2 3 V bis 5 V.

Ein Pol A eines Vierpols ist sourceseitig der ersten Schaltvorrichtung 7 ausgebildet. Weiterhin bildet der zweite Anschluss 27 des ersten elektrischen Energiespeichers 3 einen Pol B des Vierpols. Ein Pol C ist sourceseitig der zweiten Schaltvorrichtung 8 ausgebildet und ein Pol D des Vierpols wird durch das Bezugspotential gebildet.

Weiterhin weist das Bordnetz 1 eine erste Stromermittlungseinheit 14 auf, die zum Ermitteln eines ersten Stromwerts eines zwischen dem ersten Anschluss 13 des ersten Energiespeichers 3 und dem ersten Knotenpunkt 10 fließenden, schematisch mittels eines Pfeils dargestellten ersten Stroms ausgebildet ist. Zudem weist das Bordnetz 1 eine zweite Stromermittlungseinheit 15 auf, die zum Ermitteln eines zweiten Stromwerts eines über die erste Schaltvorrichtung 7 fließenden, schematisch mittels eines Pfeils dargestellten zweiten Stroms ausgebildet ist. Weiterhin weist das Bordnetz 1 eine dritte Stromermittlungseinheit 16 auf, die zum Ermitteln eines dritten Stromwerts eines zwischen dem ersten Anschluss 9 des zweiten Energiespeichers 5 und dem zweiten Knotenpunkt 11 fließenden dritten, schematisch mittels eines Pfeils dargestellten Stroms ausgebildet ist. Darüber hinaus weist das Bordnetz 1 eine vierte Stromermittlungseinheit 17 auf, die zum Ermitteln eines vierten Stromwerts eines zwischen dem ersten Knotenpunkt 10 und dem DC/DC-Wandler 6 fließenden vierten, schematisch mittels eines Pfeils dargestellten Stroms ausgebildet ist.

Ferner weist das Modul 51 einen in Figur 2 nicht näher dargestellten elektrischen Widerstand auf, wobei der elektrische Widerstand mittels einer in Figur 2 ebenfalls nicht näher dargestellten dritten Schaltvorrichtung mit dem ersten Anschluss 9 des zweiten Energiespeichers 5 elektrisch koppelbar ist. Darüber hinaus weist das Modul 51 eine in Figur 2 nicht näher dargestellte Spannungsermittlungseinheit auf, wobei die Spannungsermittlungseinheit ausgebildet ist zum Ermitteln eines ersten Spannungswerts einer Spannung des zweiten Energiespeichers 5, wenn der elektrische Widerstand von dem ersten Anschluss 9 des zweiten Energiespeichers 5 elektrisch getrennt ist und zum Ermitteln eines zweiten Spannungswerts der Spannung des zweiten Energiespeichers 5, wenn der elektrische Widerstand mit dem ersten Anschluss 9 des zweiten Energiespeichers 5 elektrisch gekoppelt ist. Zudem weist das Modul 51 eine in Figur 2 nicht näher dargestellten Innenwiderstands-Ermittlungseinheit auf, wobei die Innenwiderstands-Ermittlungseinheit ausgebildet ist zum Ermitteln eines, einen Innenwiderstand des zweiten Energiespeichers 5 kennzeichnenden Widerstandswerts basierend auf dem ermittelten ersten Spannungswert und dem ermittelten zweiten Spannungswert und zum Klassifizieren des ermittelten Widerstandswerts basierend auf den ermittelten ersten, zweiten, dritten und vierten Stromwerten.

Das Ermitteln des den Innenwiderstand des zweiten Energiespeichers 5 kennzeichnenden Widerstandswerts basierend auf dem ermittelten ersten Spannungswert und dem ermittelten zweiten Spannungswert sowie das Klassifizieren des ermittelten Widerstandswerts basierend auf den ermittelten ersten, zweiten, dritten und vierten Stromwerten erfolgt dabei entsprechend der in Figur 1A erläuterten Weise.

Figur 3 zeigt ein Blockschaltbild des in den Figuren 1A bis 2 gezeigten Moduls 51 gemäß einer Ausführungsform. Komponenten mit den gleichen Funktionen wie in den vorhergehenden Figuren werden mit den gleichen Bezugszeichen gekennzeichnet und im Folgenden nicht nochmals erläutert.

Das Modul 51, welches zumindest teilweise monolithisch integriert sein kann, beinhaltet Überwachungseinheiten in Form eines Moduls 52 sowie einer bereits im Zusammenhang mit den vorhergehenden Figuren erläuterten Spannungsermittlungseinheit 20. Die Spannungsermittlungseinheit 20 erfasst dabei die Spannung $U_{BAT\_ES2}$. Das Modul 52 sowie die Spannungsermittlungseinheit 20 können auch in einer gemeinsamen Einheit zusammengefasst werden.

Weiterhin beinhaltet das Modul 51 einen bereits im Zusammenhang mit den vorhergehenden Figuren erläuterten elektrischen Widerstand 18, der den oben erläuterten Belastungswiderstand $R_{ADD}$ bildet, eine ebenfalls bereits im Zusammenhang mit den vorhergehenden Figuren erläuterte dritte Schaltvorrichtung 19 sowie in der gezeigten Ausführungsform zudem eine vierte Schaltvorrichtung 53. Der elektrische Widerstand 18 ist beispielsweise als Chipwiderstand mit einem vorbestimmten Widerstandswert ausgebildet. Der Widerstandswert wird dabei typischerweise derart gewählt, dass ein Spannungsabfall bei Belastung mit dem Widerstand 18, d.h. bei geschlossener dritter Schaltvorrichtung 19, ungefähr 0,5 bis ein Prozent der Nominalspannung des zweiten Bordnetzzweigs beträgt.

Das Modul 52 steuert die dritte Schaltvorrichtung 19 sowie die vierte Schaltvorrichtung 53. Dazu ist das Modul 52 über eine Steuerleitung 55 mit der dritten Schaltvorrichtung 19 sowie über eine Steuerleitung 56 mit der vierten Schaltvorrichtung 53 verbunden. Ferner erfasst das Modul 52 die Systemgrößen erster, zweiter, dritter und vierter Stromwert und ist dazu mit den Signalleitungen 57, 58, 59 und 60 verbunden.

Die dritte Schaltvorrichtung 19 und der elektrische Widerstands 18 arbeiten in Abhängigkeit der Stellung der vierten Schaltvorrichtung 53. Eine erste Stellung der vierten Schaltvorrichtung 53 koppelt den elektrischen Widerstands 18 mit einem Bezugspotential 54 in Form eines Massepotentials, eine zweite Stellung koppelt den elektrischen Widerstands 18 in der gezeigten Ausführungsform mit dem Pol D.

Der Innenwiderstand der dritten Schaltvorrichtung 19 sowie der vierten Schaltvorrichtung 53 ist dabei typischerweise klein gegenüber dem elektrischen Widerstands 18, um einen Fehlerbeitrag bei der Ermittlung des Innenwiderstands des zweiten Energiespeichers gering zu halten.

Eine übergeordnete Steuereinheit, welche eine bereits im Zusammenhang mit den vorhergehenden Figuren erläutete Innenwiderstands-Ermittlungseinheit 21 bildet, kontrolliert die Schalt- und Messsequenz. Die Innenwiderstands-Ermittlungseinheit 21 konfiguriert dabei sämtliche Funktionsblöcke innerhalb des Moduls 51. Die Innenwiderstands-Ermittlungseinheit 21 besitzt die Möglichkeit, den Zustand aller Module, d.h. des Moduls 52 sowie der Spannungsermittlungseinheit 20 zu diagnostizieren.

Ferner ermittelt die Innenwiderstands-Ermittlungseinheit 21 insbesondere einen den Innenwiderstand des zweiten Energiespeichers kennzeichnenden Widerstandswert, wie nachfolgend weiter dargestellt wird.

Dazu werden die oben erläuterten ersten, zweiten, dritten und vierten Stromwerte über die Signalleitungen 57, 58, 59 und 60 eingelesen.

Weiterhin eingelesen wird die Spannung $U_{BAT\_ES2}$ des zweiten Energiespeichers. Die ersten, zweiten, dritten und vierten Stromwerte sowie die Spannung des zweiten Energiespeichers werden im Wesentlichen zeitgleich erfasst.

Die Innenwiderstands-Ermittlungseinheit 21 ermittelt die Systemwiderstände, insbesondere einen den Innenwiderstand des zweiten Energiespeichers kennzeichnenden Widerstandswert. In Verbindung mit den Systemsignalen erste, zweite, dritte und vierte Stromwerte sowie Spannung des zweiten Energiespeichers vor und während des Aufschaltens des elektrischen Widerstands 18 plausibilisiert die Innenwiderstands-Ermittlungseinheit 21 die errechneten Systemwiderstände. Die Innenwiderstands-Ermittlungseinheit 21 kann die berechneten Systemparameter zudem an eine weitere Steuereinheit im Gesamtsystem übergeben.

Ferner besitz die Innenwiderstands-Ermittlungseinheit 21 die Möglichkeit, in einem adaptiven Prozess die Einschaltzeit des elektrischen Widerstands 18 zu optimieren, d.h. zu minimieren, wie im Zusammenhang mit der folgenden Figur näher erläutert wird. Zudem kann die Deaktivierungszeit der dritten Schaltvorrichtung 19 konfiguriert werden.

Das Modul 51 kann teilmonolithisch mit den Ansteuereinheiten 41, 42 und 43 integriert sein. Dabei bedeutet teilmonolithisch, dass die Innenwiderstands-Ermittlungseinheit 21, die dritte Schaltvorrichtung 19, die vierte Schaltvorrichtung 53 sowie der elektrische Widerstands 18 von der Integration ausgenommen sind.

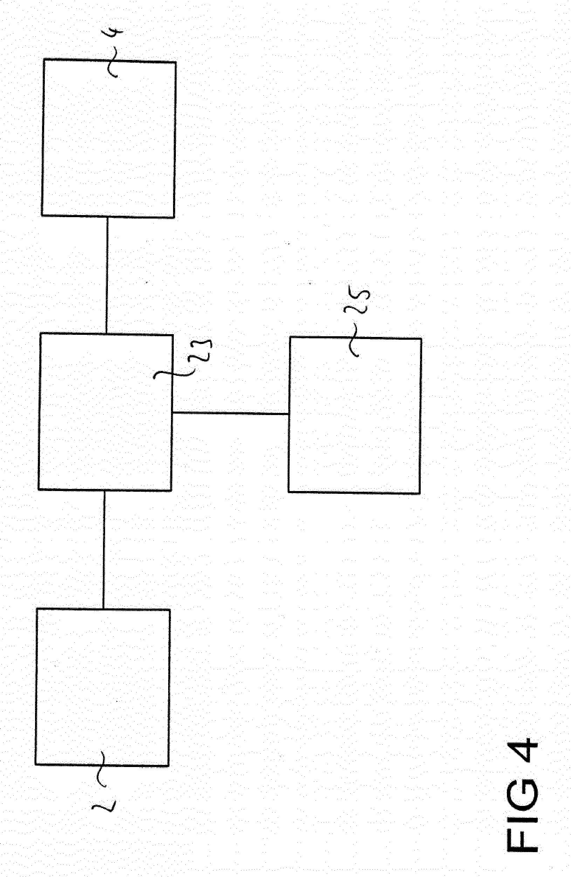

Figur 4 zeigt ein Prinzipschaltbild von Bordnetzen gemäß der Erfindung. Komponenten mit den gleichen Funktionen wie in den vorhergehenden Figuren werden mit den gleichen Bezugszeichen gekennzeichnet und im Folgenden nicht nochmals erläutert.

Wie in Figur 4 schematisch dargestellt ist, kann ein Energieaustausch zwischen dem ersten Bordnetzzweig 2, der ein erstes Energiesystem Esys1 bildet, dem zweiten Bordnetzzweig 4, der ein zweites Energiesystem Esys2 bildet, und dem dritten Bordnetzzweig 25, der ein drittes Energiesystem Esys3 bildet, mittels der Steuereinheit 23 erfolgen. Die Steuereinheit 23 verbindet die drei Energiesysteme Esys1, Esys2 und Esys3 miteinander und ermöglicht damit den Energieaustausch zwischen den drei Systemen.

Insbesondere Bordnetze in Fahrzeugen können aus den drei Energiesystemen Esys1, Esys2 und Esys3 bestehen bzw. diese aufweisen. Innerhalb des Energiesystems Esys1 können beispielhaft Blei-Akkumulatoren eingesetzt werden.

Innerhalb der Energiesysteme, besonders bei Esys2, werden ferner Energiespeicher wie beispielsweise Doppelschichtkondensatoren oder Lithium-Ionen-Zellen eingesetzt. Diese Energiespeicher werden verwendet, um bei einem Spannungseinbruch in Esys1, beispielsweise bei einem Motorstart, Energie für sensitive Systemlasten zur Verfügung zu stellen. Der Generator, der beispielsweise in Esys3 integriert ist, stellt die Energie für Esys1 und Esys2 zur Verfügung.

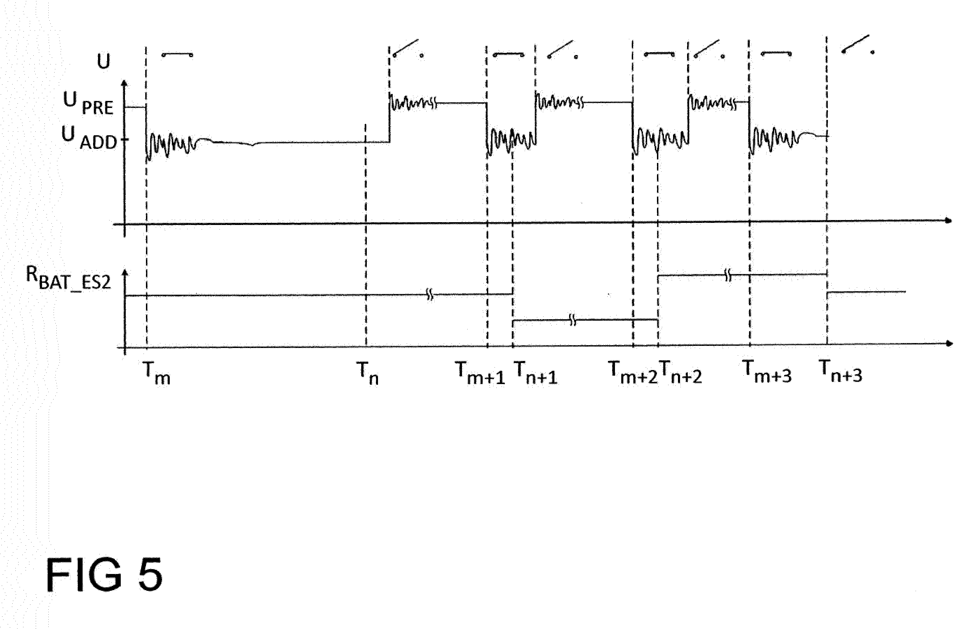

Figur 5 zeigt ein Beispiel einer Konfigurationsmöglichkeit der Dauer des geschlossenen Zustands der in Figur 3 gezeigten dritten Schaltvorrichtung.

Dazu zeigt Figur 5 eine Darstellung des zeitlichen Verlaufs der Spannung U des zweiten Energiespeichers sowie des daraus ermittelten, den Innenwiderstand des zweiten Energiespeichers kennzeichnenden Widerstandswerts, welcher in Figur 5 mit $R_{BAT\_ES2}$ bezeichnet ist.

Durch eine Variation der Belastungszeiten, d.h. der Dauer des geschlossenen Zustands der in Figur 3 dargestellten dritten Schaltvorrichtung 19 und damit der Zeitdauer des Zustands, in welchem der elektrische Widerstand mit dem ersten Anschluss des zweiten Energiespeichers elektrisch gekoppelt ist, mit einer entsprechenden Plausibilisierung der daraus resultierenden Messergebnisse kann sich der Messmechanismus selbständig auf eine Systemcharakteristik einstellen bzw. auf diese eingestellt werden. Unter der Systemcharakteristik werden dabei die in einem Ersatzschaltbild darstellbaren statischen und/oder dynamischen Impedanzen der Gesamtanordnung verstanden.

Ist der Zeitpunkt für die Spannungsmessung des zweiten Energiespeichers nach Aufschalten des Lastwiderstandes $R_{ADD}$ relativ zu den Systemzeitkonstanten nicht geeignet gewählt, werden unzutreffende Widerstandswerte für den Innenwiderstand des zweiten Energiespeichers ermittelt. Ein "Einschwingen" der Spannung an dem Messpunkt C bzw. D sollte erfolgt sein, um den Messfehler zu minimieren.

Eine zu lange Aktivierung der dritten Schaltvorrichtung, deren Schaltzustände in Figur 5 schematisch dargestellt sind, hat dagegen zur Folge, dass der Lastwiderstand $R_{ADD}$ eine erhöhte Verlustleistung generiert. Eine Verbesserung des Messergebnisses wird dadurch hingegen nicht erzielt.

In Figur 5 ist eine selbständige Optimierung der Messung durch Verringerung der Messintervalle bis zum kürzestmöglichen mit akzeptabel genauem Messwert dargestellt, wobei ein geschlossener Zustand der dritten Schaltvorrichtung in Figur 5 durch ein geschlossenes Schaltersymbol und ein geöffneter Zustand der dritten Schaltvorrichtung durch ein geöffnetes Schaltersymbol dargestellt sind.

Dabei wird die dritte Schaltvorrichtung zu den Zeitpunkten $T_m$, $T_{m+1}$, $T_{m+2}$ sowie $T_{m+3}$ geschlossen. Die Messung der Spannung des zweiten Energiespeichers in geschlossenem Schaltzustand der dritten Schaltvorrichtung erfolgt jeweils zu den Zeitpunkten $T_n$, $T_{n+1}$, $T_{n+2}$ sowie $T_{n+3}$. Zu den Zeitpunkten $T_{n+1}$ und $T_{n+2}$ ist der Einschwingvorgang der Spannung des zweiten Energiespeichers nach dem Schließen der dritten Schaltvorrichtung noch nicht beendet. Die Messung der Spannung des zweiten Energiespeichers zu dem Zeitpunkt $T_n$ führt hingegen zu einer langen Aktivierung der dritten Schaltvorrichtung und damit zu einer erhöhte Verlustleistung. Der Zeitpunkt $T_{n+3}$ bildet einen möglichst optimalen Zeitpunkt für die Messung der Spannung des zweiten Energiespeichers in geschlossenem Schaltzustand der dritten Schaltvorrichtung. Nach der zu dem Zeitpunkt $T_{n+3}$ erfolgten Messung der Spannung wird die dritte Schaltvorrichtung anschließend wieder geöffnet.

Eine Variation der Dauer des geschlossenen Zustands der dritten Schaltvorrichtung und damit der Zeitdauer des Zustands, in welchem der elektrische Widerstand mit dem ersten Anschluss des zweiten Energiespeichers elektrisch gekoppelt ist, kann dabei über einen bevorzugt monolithisch integrierten, justierbaren Timer erfolgen. Der Vorteil einer monolithischen Integration liegt dabei darin, dass eine Überlastung des elektrischen Widerstands in zuverlässiger Weise vermieden werden kann.

Dadurch wird die Möglichkeit bereitgestellt, durch einen adaptiven Mechanismus einen geeigneten Messzeitpunkt kontinuierlich zu ermitteln und damit eine höhere Messgenauigkeit zu erreichen sowie die Verlustleistung der Messanordnung möglichst gering zu halten. Der adaptive Mechanismus wird dabei typischerweise mindesten einmal pro Fahrtzyklus des Fahrzeugs durchgeführt.

Bezugszeichenliste

| 1 | Bordnetz |
|---|---|
| 2 | Bordnetzzweig |
| 3 | Energiespeicher |
| 4 | Bordnetzzweig |
| 5 | Energiespeicher |
| 6 | DC/DC-Wandler |
| 7, 8 | Schaltvorrichtung |
| 9 | Anschluss |
| 10 - 12 | Knotenpunkt |
| 13 | Anschluss |
| 14 - 17 | Stromermittlungseinheit |
| 18 | Widerstand |
| 19 | Schaltvorrichtung |
| 20 | Spannungsermittlungseinheit |
| 21 | Innenwiderstands-Ermittlungseinheit |
| 22 | Verbraucher |
| 23 | Steuereinheit |
| 24 | Verbraucher |
| 25 | Bordnetzzweig |
| 26 | Verbraucher |
| 27 - 39 | Anschluss |
| 40 | Generator |
| 41 - 43 | Ansteuereinheit |
| 44 | Knotenpunkt |
| 45 - 47 | Widerstand |
| 48 | Starter |
| 49 - 50 | Anschluss |
| 51, 52 | Modul |
| 53 | Schaltvorrichtung |
| 54 | Bezugspotential |
| 55, 56 | Steuerleitung |
| 57 - 60 | Signalleitung |
| 61 | Messleitung |
| 62 | Spannungsabgriff |
| 63 | Anschluss |
| A - D | Pol |

**Patentansprüche**

**1.** Bordnetz für ein Fahrzeug aufweisend

- einen ersten Bordnetzzweig (2), wobei der erste Bordnetzzweig (2) einen ersten Energiespeicher (3) aufweist,

- einen zweiten Bordnetzzweig (4), wobei der zweite Bordnetzzweig (4) einen zweiten Energiespeicher (5) aufweist,
- einen DC/DC-Wandler (6), ausgebildet zum bidirektionalen Übertragen von Energie zwischen dem ersten Bordnetzzweig (2) und dem zweiten Bordnetzzweig (4),
- eine erste Schaltvorrichtung (7) und eine zweite Schaltvorrichtung (8), wobei ein erster Anschluss (9) des zweiten Energiespeichers (5) mittels der ersten Schaltvorrichtung (7) und der zweiten Schaltvorrichtung (8) über einen ersten Knotenpunkt (10), einen zweiten Knotenpunkt (11) und einen dritten Knotenpunkt (12) mit einem ersten Anschluss (13) des ersten Energiespeichers (3) elektrisch koppelbar ist,
- eine erste Stromermittlungseinheit (14) ausgebildet zum Ermitteln eines ersten Stromwerts eines zwischen dem ersten Anschluss (13) des ersten Energiespeichers (3) und dem ersten Knotenpunkt (10) fließenden ersten Stroms,
- eine zweite Stromermittlungseinheit (15) ausgebildet zum Ermitteln eines zweiten Stromwerts eines über die erste Schaltvorrichtung (7) und die zweite Schaltvorrichtung (8) fließenden zweiten Stroms,
- eine dritte Stromermittlungseinheit (16) ausgebildet zum Ermitteln eines dritten Stromwerts eines zwischen dem ersten Anschluss (9) des zweiten Energiespeichers (5) und dem zweiten Knotenpunkt (11) fließenden dritten Stroms,
- eine vierte Stromermittlungseinheit (17) ausgebildet zum Ermitteln eines vierten Stromwerts eines zwischen dem dritten Knotenpunkt (12) und dem DC/DC-Wandler (6) fließenden vierten Stroms,
- einen elektrischen Widerstand (18), wobei der elektrische Widerstand (18) mittels einer dritten Schaltvorrichtung (19) mit dem ersten Anschluss (9) des zweiten Energiespeichers (5) elektrisch koppelbar ist,
- eine Spannungsermittlungseinheit (20), wobei die Spannungsermittlungseinheit (20) ausgebildet ist zum Ermitteln eines ersten Spannungswerts einer Spannung des zweiten Energiespeichers (5), wenn der elektrische Widerstand (18) von dem ersten Anschluss (9) des zweiten Energiespeichers (5) elektrisch getrennt ist und zum Ermitteln eines zweiten Spannungswerts der Spannung des zweiten Energiespeichers (5), wenn der elektrische Widerstand (18) mit dem ersten Anschluss (9) des zweiten Energiespeichers (5) elektrisch gekoppelt ist,
- eine Innenwiderstands-Ermittlungseinheit (21), wobei die Innenwiderstands-Ermittlungseinheit (21) ausgebildet ist zum Ermitteln eines, einen Innenwiderstand des zweiten Energiespeichers (5) kennzeichnenden Widerstandswerts basierend auf dem ermittelten ersten Spannungswert und dem ermittelten zweiten Spannungswert und zum Klassifizieren des ermittelten Widerstandswerts basierend auf den ermittelten ersten, zweiten, dritten und vierten Stromwerten.

2. Bordnetz für ein Fahrzeug aufweisend

- einen ersten Bordnetzzweig (2), wobei der erste Bordnetzzweig (2) einen ersten Energiespeicher (3) aufweist,
- einen zweiten Bordnetzzweig (4), wobei der zweite Bordnetzzweig (4) einen zweiten Energiespeicher (5) aufweist, wobei ein erster Anschluss (9) des zweiten Energiespeichers (5) über einen ersten Knotenpunkt (10) und einen zweiten Knotenpunkt (11) mit einem ersten Anschluss (13) des ersten Energiespeichers (3) elektrisch koppelbar ist,
- einen DC/DC-Wandler (6), ausgebildet zum bidirektionalen Übertragen von Energie zwischen dem ersten Bordnetzzweig (2) und dem zweiten Bordnetzzweig (4),
- eine erste Schaltvorrichtung (7) und eine zweite Schaltvorrichtung (8), wobei der erste Anschluss (9) des zweiten Energiespeichers (5) mittels der ersten Schaltvorrichtung (7) und der zweiten Schaltvorrichtung (8) mit einem Bezugspotential elektrisch koppelbar ist,
- eine erste Stromermittlungseinheit (14) ausgebildet zum Ermitteln eines ersten Stromwerts eines zwischen dem ersten Anschluss (13) des ersten Energiespeichers (3) und dem ersten Knotenpunkt (10) fließenden ersten Stroms,
- eine zweite Stromermittlungseinheit (15) ausgebildet zum Ermitteln eines zweiten Stromwerts eines über die erste Schaltvorrichtung (7) fließenden zweiten Stroms,
- eine dritte Stromermittlungseinheit (16) ausgebildet zum Ermitteln eines dritten Stromwerts eines zwischen dem ersten Anschluss (9) des zweiten Energiespeichers (5) und dem zweiten Knotenpunkt (11) fließenden dritten Stroms,
- eine vierte Stromermittlungseinheit (17) ausgebildet zum Ermitteln eines vierten Stromwerts eines zwischen dem ersten Knotenpunkt (10) und dem DC/DC-Wandler (6) und/oder eines zwischen dem zweiten Knotenpunkt (11) und dem DC/DC-Wandler (6) fließenden vierten Stroms,
- einen elektrischen Widerstand (18), wobei der elektrische Widerstand (18) mittels einer dritten Schaltvorrichtung (19) mit dem ersten Anschluss (9) des zweiten Energiespeichers (5) elektrisch koppelbar ist,
- eine Spannungsermittlungseinheit (20), wobei die Spannungsermittlungseinheit (20) ausgebildet ist zum Ermitteln eines ersten Spannungswerts einer Spannung des zweiten Energiespeichers (5), wenn der elektrische Widerstand (18) von dem ersten Anschluss (9) des zweiten Energiespeichers (5) elektrisch getrennt ist und zum Ermitteln eines zweiten Spannungswerts der Spannung des zweiten Energiespeichers (5), wenn der elektrische Widerstand (18) mit dem ersten Anschluss (9) des zweiten Energiespeichers (5) elektrisch gekoppelt ist, - eine Innenwiderstands-Ermittlungseinheit (21), wobei die Innenwiderstands-Ermittlungseinheit (21) ausgebildet ist zum Ermitteln eines, einen Innenwiderstand des zweiten Energiespeichers (5) kennzeichnenden Widerstandswerts basierend auf dem ermittelten ersten Spannungswert und dem ermittelten zweiten Spannungswert und zum Klassifizieren des ermittelten Widerstandswerts basierend auf den ermittelten ersten, zweiten, dritten und vierten Stromwerten.

3.  Bordnetz nach Anspruch 1 oder Anspruch 2, wobei der elektrische Widerstand (18) einen vorbestimmten Widerstandswert aufweist.

4.  Bordnetz nach einem der vorhergehenden Ansprüche, wobei die Innenwiderstands-Ermittlungseinheit (21) zudem ausgebildet ist zum Klassifizieren des ermittelten Widerstandswerts basierend auf dem ermittelten ersten Spannungswert und dem ermittelten zweiten Spannungswert.

5.  Bordnetz nach einem der vorhergehenden Ansprüche, wobei der erste Bordnetzzweig (2) zudem einen ersten elektrischen Verbraucher (22) aufweist.

6.  Bordnetz nach einem der vorhergehenden Ansprüche, wobei der DC/DC-Wandler (6), die erste Schaltvorrichtung (7), die zweite Schaltvorrichtung (8), die dritte Schaltvorrichtung (19), der elektrische Widerstand (18) und die Innenwiderstands-Ermittlungseinheit (21) Bestandteil einer Steuereinheit (23) sind.

7.  Bordnetz nach einem der vorhergehenden Ansprüche, wobei die erste Schaltvorrichtung (7), die zweite Schaltvorrichtung (8) und die dritte Schaltvorrichtung (19) ausgewählt sind aus der Gruppe, bestehend aus einem Relais und einem Halbleiterschalter.

8.  Bordnetz nach einem der vorhergehenden Ansprüche, wobei der zweite Bordnetzzweig (4) zudem einen zweiten elektrischen Verbraucher (24) aufweist.

9.  Bordnetz nach einem der vorhergehenden Ansprüche, weiterhin aufweisend einen dritten Bordnetzzweig (25), wobei der dritte Bordnetzzweig (25) einen dritten elektrischen Verbraucher (26) aufweist.

10. Verfahren zum Betreiben eines Bordnetzes nach einem der Ansprüche 1 bis 9, wobei das Verfahren folgende Schritte aufweist:

    - Ermitteln eines ersten Spannungswerts einer Spannung des zweiten Energiespeichers (5) mittels der Spannungsermittlungseinheit (20), eines ersten Stromwerts mittels der ersten Stromermittlungseinheit (14), eines zweiten Stromwerts mittels der zweiten Stromermittlungseinheit (15), eines dritten Stromwerts mittels der dritten Stromermittlungseinheit (16) und eines vierten Stromwerts mittels der vierten Stromermittlungseinheit (17), wenn der elektrische Widerstand (18) von dem ersten Anschluss (9) des zweiten Energiespeichers (5) elektrisch getrennt ist,
    - Schließen der dritten Schaltvorrichtung (19),
    - Ermitteln eines zweiten Spannungswerts der Spannung des zweiten Energiespeichers (5) und wiederholtes Ermitteln eines ersten Stromwerts mittels der ersten Stromermittlungseinheit (14), eines zweiten Stromwerts mittels der zweiten Stromermittlungseinheit (15), eines dritten Stromwerts mittels der dritten Stromermittlungseinheit (16) und eines vierten Stromwerts mittels der vierten Stromermittlungseinheit (17), wenn der elektrische Widerstand (18) mit dem ersten Anschluss (9) des zweiten Energiespeichers (5) elektrisch gekoppelt ist,
    - Ermitteln eines, einen Innenwiderstand des zweiten Energiespeichers (5) kennzeichnenden Widerstandswerts basierend auf dem ermittelten ersten Spannungswert und dem ermittelten zweiten Spannungswert,
    - Klassifizieren des ermittelten Widerstandswerts basierend auf den ermittelten ersten, zweiten, dritten und vierten Stromwerten.

11. Verfahren nach Anspruch 10, wobei das Klassifizieren des ermittelten Widerstandswerts ein Vergleichen jeweils der vor und nach dem Schließen der dritten Schaltvorrichtung (19) ermittelten ersten Stromwerte, der vor und nach dem Schließen der dritten Schaltvorrichtung (19) ermittelten zweiten Stromwerte, der vor und nach dem Schließen der dritten Schaltvorrichtung (19) ermittelten dritten Stromwerte und der vor und nach dem Schließen der dritten Schaltvorrichtung (19) ermittelten vierten Stromwerte miteinander beinhaltet.

**12.** Verfahren nach Anspruch 10 oder Anspruch 11, wobei das Klassifizieren des ermittelten Widerstandswerts zudem basierend auf dem ermittelten ersten Spannungswert und dem ermittelten zweiten Spannungswert erfolgt.

**13.** Verfahren nach einem der Ansprüche 10 bis 12, wobei zudem eine Zeitermittlung erfolgt, nachdem die dritte Schaltvorrichtung (19) geschlossen wurde und wobei das Ermitteln des zweiten Spannungswerts nach einer vorbestimmten Zeitdauer nach dem Beginn der Zeitermittlung erfolgt.

**14.** Verfahren nach einem der Ansprüche 10 bis 12, wobei nach dem Schließen der dritten Schaltvorrichtung (19) die Spannung des zweiten Energiespeichers (5) wiederholt ermittelt wird und wobei der zweite Spannungswert ermittelt wird, wenn eine Abweichung von aufeinanderfolgend ermittelten Werten der Spannung voneinander einen vorbestimmten Schwellenwert unterschreitet.

**15.** Verfahren nach einem der Ansprüche 10 bis 14, wobei das Verfahren nach dem Ermitteln des den Innenwiderstand des zweiten Energiespeichers (5) kennzeichnenden Widerstandswerts zudem folgende Schritte aufweist:

- Öffnen der dritten Schaltvorrichtung (19),
- Ermitteln eines dritten Spannungswerts der Spannung des zweiten Energiespeichers (5) und wiederholtes Ermitteln eines ersten Stromwerts mittels der ersten Stromermittlungseinheit (14), eines zweiten Stromwerts mittels der zweiten Stromermittlungseinheit (15), eines dritten Stromwerts mittels der dritten Stromermittlungseinheit (16) und eines vierten Stromwerts mittels der vierten Stromermittlungseinheit (17), wenn der elektrische Widerstand (18) von dem ersten Anschluss (9) des zweiten Energiespeichers (5) elektrisch getrennt ist,

wobei das Klassifizieren des ermittelten Widerstandswerts zudem basierend auf dem ermittelten dritten Spannungswert und den ermittelten ersten, zweiten, dritten und vierten Stromwerten, die ermittelt werden, wenn der elektrische Widerstand (18) von dem ersten Anschluss (9) des zweiten Energiespeichers (5) elektrisch getrennt ist, erfolgt.

**Claims**

**1.** On-board electrical system for a vehicle comprising

- a first on-board electrical system branch (2), wherein the first on-board electrical system branch (2) comprises a first energy store (3),
- a second on-board electrical system branch (4), wherein the second on-board electrical system branch (4) comprises a second energy store (5),
- a DC/DC converter (6), designed for bidirectionally transferring energy between the first on-board electrical system branch (2) and the second on-board electrical system branch (4),
- a first switching device (7) and a second switching device (8), wherein a first terminal (9) of the second energy store (5) is electrically couplable to a first terminal (13) of the first energy store (3) via a first node (10), a second node (11) and a third node (12) by means of the first switching device (7) and the second switching device (8),
- a first current determining unit (14) designed for determining a first current value of a first current flowing between the first terminal (13) of the first energy store (3) and the first node (10),
- a second current determining unit (15) designed for determining a second current value of a second current flowing via the first switching device (7) and the second switching device (8),
- a third current determining unit (16) designed for determining a third current value of a third current flowing between the first terminal (9) of the second energy store (5) and the second node (11),
- a fourth current determining unit (17) designed for determining a fourth current value of a fourth current flowing between the third node (12) and the DC/DC converter (6),
- an electrical resistor (18), wherein the electrical resistor (18) is electrically couplable to the first terminal (9) of the second energy store (5) by means of a third switching device (19),
- a voltage determining unit (20), wherein the voltage determining unit (20) is designed for determining a first voltage value of a voltage of the second energy store (5) if the electrical resistor (18) is electrically isolated from the first terminal (9) of the second energy store (5) and for determining a second voltage value of the voltage of the second energy store (5) if the electrical resistor (18) is electrically coupled to the first terminal (9) of the second energy store (5),
- an internal resistance determining unit (21), wherein the internal resistance determining unit (21) is designed for determining a resistance value characterizing an internal resistance of the second energy store (5) on the basis of the determined first voltage value and the determined second voltage value and for classifying the determined resistance value on the basis of the determined first, second, third and fourth current values.

2. On-board electrical system for a vehicle comprising

- a first on-board electrical system branch (2), wherein the first on-board electrical system branch (2) comprises a first energy store (3),
- a second on-board electrical system branch (4), wherein the second on-board electrical system branch (4) comprises a second energy store (5), wherein a first terminal (9) of the second energy store (5) is electrically couplable to a first terminal (13) of the first energy store (3) via a first node (10) and a second node (11),
- a DC/DC converter (6), designed for bidirectionally transferring energy between the first on-board electrical system branch (2) and the second on-board electrical system branch (4),
- a first switching device (7) and a second switching device (8), wherein the first terminal (9) of the second energy store (5) is electrically couplable to a reference potential by means of the first switching device (7) and the second switching device (8),
- a first current determining unit (14) designed for determining a first current value of a first current flowing between the first terminal (13) of the first energy store (3) and the first node (10),
- a second current determining unit (15) designed for determining a second current value of a second current flowing via the first switching device (7),
- a third current determining unit (16) designed for determining a third current value of a third current flowing between the first terminal (9) of the second energy store (5) and the second node (11),
- a fourth current determining unit (17) designed for determining a fourth current value of a fourth current flowing between the first node (10) and the DC/DC converter (6) and/or a fourth current flowing between the second node (11) and the DC/DC converter (6),
- an electrical resistor (18), wherein the electrical resistor (18) is electrically couplable to the first terminal (9) of the second energy store (5) by means of a third switching device (19),
- a voltage determining unit (20), wherein the voltage determining unit (20) is designed for determining a first voltage value of a voltage of the second energy store (5) if the electrical resistor (18) is electrically isolated from the first terminal (9) of the second energy store (5) and for determining a second voltage value of the voltage of the second energy store (5) if the electrical resistor (18) is electrically coupled to the first terminal (9) of the second energy store (5),
- an internal resistance determining unit (21), wherein the internal resistance determining unit (21) is designed for determining a resistance value characterizing an internal resistance of the second energy store (5) on the basis of the determined first voltage value and the determined second voltage value and for classifying the determined resistance value on the basis of the determined first, second, third and fourth current values.

3. On-board electrical system according to Claim 1 or Claim 2, wherein the electrical resistor (18) has a predetermined resistance value.

4. On-board electrical system according to any of the preceding claims, wherein the internal resistance determining unit (21) is additionally designed for classifying the determined resistance value on the basis of the determined first voltage value and the determined second voltage value.

5. On-board electrical system according to any of the preceding claims, wherein the first on-board electrical system branch (2) additionally comprises a first electrical load (22).

6. On-board electrical system according to any of the preceding claims, wherein the DC/DC converter (6), the first switching device (7), the second switching device (8), the third switching device (19), the electrical resistor (18) and the internal resistance determining unit (21) are part of a control unit (23).

7. On-board electrical system according to any of the preceding claims, wherein the first switching device (7), the second switching device (8), the third switching device (19) are selected from the group consisting of a relay and a semiconductor switch.

8. On-board electrical system according to any of the preceding claims, wherein the second on-board electrical system branch (4) additionally comprises a second electrical load (24).

9. On-board electrical system according to any of the preceding claims, furthermore comprising a third on-board electrical system branch (25), wherein the third on-board electrical system branch (25) comprises a third electrical load (26).

10. Method for operating an on-board electrical system according to any of Claims 1 to 9, wherein the method comprises the following steps:

- determining a first voltage value of a voltage of the second energy store (5) by means of the voltage determining unit (20), a first current value by means of the first current determining unit (14), a second current value by means of the second current determining unit (15), a third current value by means of the third current determining unit (16) and a fourth current value by means of the fourth current determining unit (17) if the electrical resistor (18) is electrically isolated from the first terminal (9) of the second energy store (5),
- closing the third switching device (19),
- determining a second voltage value of the voltage of the second energy store (5) and repeatedly determining a first current value by means of the first current determining unit (14), a second current value by means of the second current determining unit (15), a third current value by means of the third current determining unit (16) and a fourth current by means of the fourth current determining unit (17) if the electrical resistor (18) is electrically coupled to the first terminal (9) of the second energy store (5),
- determining a resistance value characterizing an internal resistance of the second energy store (5) on the basis of the determined first voltage value and the determined second voltage value,
- classifying the determined resistance value on the basis of the determined first, second, third and fourth current values.

11. Method according to Claim 10, wherein classifying the determined resistance value comprises comparing in each case the first current values determined before and after the closing of the third switching device (19), the second current values determined before and after the closing of the third switching device (19), the third current values determined before and after the closing of the third switching device (19) and the fourth current values determined before and after the closing of the third switching device (19) with one another.

12. Method according to Claim 10 or Claim 11, wherein classifying the determined resistance value is additionally carried out on the basis of the determined first voltage value and the determined second voltage value.

13. Method according to any of Claims 10 to 12, wherein a time determination is additionally carried out after the third switching device (19) has been closed, and wherein determining the second voltage value is carried out after a predetermined time duration after the beginning of the time determination.

14. Method according to any of Claims 10 to 12, wherein, after the closing of the third switching device (19), the voltage of the second energy store (5) is repeatedly determined, and wherein the second voltage value is determined if a deviation of successively determined values of the voltage from one another falls below a predetermined threshold value.

15. Method according to any of Claims 10 to 14, wherein the method additionally comprises the following steps after determining the resistance value characterizing the internal resistance of the second energy store (5):

- opening the third switching device (19),
- determining a third voltage value of the voltage of the second energy store (5) and repeatedly determining a first current value by means of the first current determining unit (14), a second current value by means of the second current determining unit (15), a third current value by means of the third current determining unit (16) and a fourth current value by means of the fourth current determining unit (17) if the electrical resistor (18) is electrically isolated from the first terminal (9) of the second energy store (5),

wherein classifying the determined resistance value is additionally carried out on the basis of the determined third voltage value and the determined first, second, third and fourth current values which are determined if the electrical resistor (18) is electrically isolated from the first terminal (9) of the second energy store (5).

**Revendications**

1. Réseau de bord destiné à un véhicule, comportant

- une première branche de réseau de bord (2), la première branche de réseau de bord (2) comportant un premier accumulateur d'énergie (3),
- une deuxième branche de réseau de bord (4), la deuxième branche de réseau de bord (4) comportant un deuxième accumulateur d'énergie (5),
- un convertisseur continu/continu (6) conçu pour transmettre de manière bidirectionnelle de l'énergie entre la première branche de réseau de bord (2) et la deuxième branche de réseau de bord (4),
- un premier dispositif de commutation (7) et un deuxième dispositif de commutation (8), une première borne (9) du deuxième accumulateur d'énergie (5) pouvant être couplée électriquement au moyen du premier dispositif de commutation (7) et du deuxième dispositif de commutation (8) par l'intermédiaire d'un premier noeud (10), d'un deuxième noeud (11) et d'un troisième noeud (12), à une première borne (13) du premier accumulateur d'énergie (3),
- une première unité de détermination de courant (14) conçue pour déterminer une première valeur de courant d'un premier courant passant entre la première borne (13) du premier accumulateur d'énergie (3) et le premier noeud (10),
- une deuxième unité de détermination de courant (15) conçue pour déterminer une deuxième valeur de courant d'un deuxième courant passant par l'intermédiaire du premier dispositif de commutation (7) et du deuxième dispositif de commutation (8),
- une troisième unité de détermination de courant (16) conçue pour déterminer une troisième valeur de courant d'un troisième courant passant entre la première borne (9) du deuxième accumulateur d'énergie (5) et le deuxième noeud (11),
- une quatrième unité de détermination de courant (17) conçue pour déterminer une quatrième valeur de courant d'un quatrième courant passant entre le troisième noeud (12) et le convertisseur continu/continu (6),
- une résistance électrique (18), la résistance électrique (18) pouvant être couplée électriquement au moyen d'un troisième dispositif de commutation (19) à la première borne (9) du deuxième accumulateur d'énergie (5),
- une unité de détermination de tension (20), l'unité de détermination de tension (20) étant conçue pour déterminer une première valeur de tension d'une tension du deuxième accumulateur d'énergie (5) lorsque la résistance électrique (18) est séparée électriquement de la première borne (9) du deuxième accumulateur d'énergie (5) et pour déterminer une deuxième valeur de tension de la tension du deuxième accumulateur d'énergie (5) lorsque la résistance électrique (18) est couplée électriquement à la première borne (9) du deuxième accumulateur d'énergie (5),
- une unité de détermination de résistance interne (21), l'unité de détermination de résistance interne (21) étant conçue pour déterminer une valeur de résistance caractérisant une résistance interne du deuxième accumulateur d'énergie (5) sur la base de la première valeur de tension déterminée et de la deuxième valeur de tension déterminée et pour classer la valeur de résistance déterminée sur la base des première, deuxième, troisième et quatrième valeurs de courant déterminées.

2. Réseau de bord destiné à un véhicule, comportant

- une première branche de réseau de bord (2), la première branche de réseau de bord (2) comportant un premier accumulateur d'énergie (3),
- une deuxième branche de réseau de bord (4), la deuxième branche de réseau de bord (4) comportant un deuxième accumulateur d'énergie (5), une première borne (9) du deuxième accumulateur d'énergie (5) pouvant être couplée électriquement par l'intermédiaire d'un premier noeud (10) et d'un deuxième noeud (11) à une première borne (13) du premier accumulateur d'énergie (3),
- un convertisseur continu/continu (6) conçu pour transmettre de manière bidirectionnelle de l'énergie entre la première branche de réseau de bord (2) et la deuxième branche de réseau de bord (4),
- un premier dispositif de commutation (7) et un deuxième dispositif de commutation (8), la première borne (9) du deuxième accumulateur d'énergie (5) pouvant être couplée électriquement au moyen du premier dispositif de commutation (7) et du deuxième dispositif de commutation (8) à un potentiel de référence,
- une première unité de détermination de courant (14) conçue pour déterminer une première valeur de courant d'un premier courant passant entre la première borne (13) du premier accumulateur d'énergie (3) et le premier noeud (10),
- une deuxième unité de détermination de courant (15) conçue pour déterminer une deuxième valeur de courant d'un deuxième courant passant par l'intermédiaire du premier dispositif de commutation (7),
- une troisième unité de détermination de courant (16) conçue pour déterminer une troisième valeur de courant d'un troisième courant passant entre la première borne (9) du deuxième accumulateur d'énergie (5) et le deuxième noeud (11),
- une quatrième unité de détermination de courant (17) conçue pour déterminer une quatrième valeur de courant d'un quatrième courant passant entre le premier noeud (10) et le convertisseur continu/continu (6) et/ou d'un quatrième courant passant entre le deuxième noeud (11) et le convertisseur continu/continu (6),

- une résistance électrique (18), la résistance électrique (18) pouvant être couplée électriquement au moyen d'un troisième dispositif de commutation (19) à la première borne (9) du deuxième accumulateur d'énergie (5),
- une unité de détermination de tension (20), l'unité de détermination de tension (20) étant conçue pour déterminer une première valeur de tension d'une tension du deuxième accumulateur d'énergie (5) lorsque la résistance électrique (18) est séparée électriquement de la première borne (9) du deuxième accumulateur d'énergie (5) et pour déterminer une deuxième valeur de tension de la tension du deuxième accumulateur d'énergie (5) lorsque la résistance électrique (18) est couplée électriquement à la première borne (9) du deuxième accumulateur d'énergie (5),
- une unité de détermination de résistance interne (21), l'unité de détermination de résistance interne (21) étant conçue pour déterminer une valeur de résistance caractérisant une résistance interne du deuxième accumulateur d'énergie (5) sur la base de la première valeur de tension déterminée et de la deuxième valeur de tension déterminée et pour classer la valeur de résistance déterminée sur la base des première, deuxième, troisième et quatrième valeurs de courant déterminées.

3. Réseau de bord selon la revendication 1 ou la revendication 2, dans lequel la résistance électrique (18) présente une valeur de résistance prédéterminée.

4. Réseau de bord selon l'une quelconque des revendications précédentes, dans lequel l'unité de détermination de résistance interne (21) est en outre conçue pour classer la valeur de résistance déterminée sur la base de la première valeur de tension déterminée et de la deuxième valeur de tension déterminée.

5. Réseau de bord selon l'une quelconque des revendications précédentes, dans lequel la première branche de réseau de bord (2) comporte en outre un premier consommateur électrique (22).

6. Réseau de bord selon l'une quelconque des revendications précédentes, dans lequel le convertisseur continu/continu (6), le premier dispositif de commutation (7), le deuxième dispositif de commutation (8), le troisième dispositif de commutation (19), la résistance électrique (18) et l'unité de détermination de résistance interne (21) font partie d'une unité de commande (23).

7. Réseau de bord selon l'une quelconque des revendications précédentes, dans lequel le premier dispositif de commutation (7), le deuxième dispositif de commutation (8) et le troisième dispositif de commutation (19) sont sélectionnés dans le groupe constitué d'un relais et d'un commutateur à semi-conducteur.

8. Réseau de bord selon l'une quelconque des revendications précédentes, dans lequel la deuxième branche de réseau de bord (4) comporte en outre un deuxième consommateur électrique (24).

9. Réseau de bord selon l'une quelconque des revendications précédentes, comportant en outre une troisième branche de réseau de bord (25), dans lequel la troisième branche de réseau de bord (25) comporte un troisième consommateur électrique (26).

10. Procédé de mise en fonctionnement d'un réseau de bord selon l'une quelconque des revendications 1 à 9, dans lequel le procédé comporte les étapes consistant à :

- déterminer une première valeur de tension d'une tension du deuxième accumulateur d'énergie (5) au moyen de l'unité de détermination de tension (20), une première valeur de courant au moyen de la première unité de détermination de courant (14), une deuxième valeur de courant au moyen de la deuxième unité de détermination de courant (15), une troisième valeur de courant au moyen de la troisième unité de détermination de courant (16) et une quatrième valeur de courant au moyen de la quatrième unité de détermination de courant (17), lorsque la résistance électrique (18) est séparée électriquement de la première borne (9) du deuxième accumulateur d'énergie (5),
- fermer le troisième dispositif de commutation (19),
- déterminer une deuxième valeur de tension de la tension du deuxième accumulateur d'énergie (5) et déterminer à nouveau une première valeur de courant au moyen de la première unité de détermination de courant (14), une deuxième valeur de courant au moyen de la deuxième unité de détermination de courant (15), une troisième valeur de courant au moyen de la troisième unité de détermination de courant (16) et une quatrième valeur de courant au moyen de la quatrième unité de détermination de courant (17), lorsque la résistance électrique (18) est couplée électriquement à la première borne (9) du deuxième accumulateur d'énergie (5),
- déterminer une valeur de résistance caractérisant une résistance interne du deuxième accumulateur d'énergie (5) sur la base de la première valeur de tension déterminée et de la deuxième valeur de tension déterminée,
- classer la valeur de résistance déterminée sur la base des première, deuxième, troisième et quatrième valeurs de courant déterminées.

11. Procédé selon la revendication 10, dans lequel la classification de la valeur de résistance déterminée comprend une comparaison les unes aux autres, respectivement, des premières valeurs de courant déterminées avant et après la fermeture du troisième dispositif de commutation (19), des deuxième valeurs de courant déterminées avant et après la fermeture du troisième dispositif de commutation (19), des troisièmes valeurs de courant déterminées avant et après la fermeture du troisième dispositif de commutation (19) et des quatrièmes valeurs de courant déterminées avant et après la fermeture du troisième dispositif de commutation (19).

12. Procédé selon la revendication 10 ou la revendication 11, dans lequel la classification de la valeur de résistance déterminée s'effectue en outre sur la base de la première valeur de tension déterminée et de la deuxième valeur de tension déterminée.

13. Procédé selon l'une quelconque des revendications 10 à 12, dans lequel on effectue en outre une détermination du temps au bout duquel le troisième dispositif de commutation (19) a été fermé et dans lequel la détermination de la deuxième valeur de tension s'effectue au bout d'un intervalle de temps prédéterminé après le début de la détermination du temps.

14. Procédé selon l'une quelconque des revendications 10 à 12, dans lequel, après la fermeture du troisième dispositif de commutation (19), la tension du deuxième accumulateur d'énergie (5) est de nouveau déterminée et dans lequel la deuxième valeur de tension est déterminée lorsqu'un écart entre des valeurs déterminées consécutivement de la tension s'abaissent en dessous d'une valeur de seuil prédéterminée.

15. Procédé selon l'une quelconque des revendications 10 à 14, dans lequel le procédé comporte en outre les étapes suivantes, après la détermination de la valeur de résistance caractérisant la résistance interne du deuxième accumulateur d'énergie (5) :

- ouvrir le troisième dispositif de commutation (19),
- déterminer une troisième valeur de tension de la tension du deuxième accumulateur d'énergie (5) et déterminer à nouveau une première valeur de courant au moyen de la première unité de détermination de courant (14), une deuxième valeur de courant au moyen de la deuxième unité de détermination de courant (15), une troisième valeur de courant au moyen de la troisième unité de détermination de courant (16) et une quatrième valeur de courant au moyen de la quatrième unité de détermination de courant (17), lorsque la résistance électrique (18) est séparée électriquement de la première borne (9) du deuxième accumulateur d'énergie (5),

la classification de la valeur de résistance déterminée s'effectuant en outre sur la base de la troisième valeur de tension déterminée et des première, deuxième, troisième et quatrième valeurs de courant déterminées, qui sont déterminées lorsque la résistance électrique (18) est séparée électriquement de la première borne (9) du deuxième accumulateur d'énergie (5).

FIG 1A

FIG 1B

EP 3 022 568 B1

FIG 2

EP 3 022 568 B1

FIG 3

FIG 4

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007006477 A1
- DE 102011086829 A1
- DE 102011087678 A1
- US 2013038289 A1
- WO 2012160754 A1